# EUROPEAN PATENT SPECIFICATION

(11) **EP 0 534 425 B1**
(45) Date of publication and mention of the grant of the patent: **10.12.1997**
(21) Application number: 92116353.1
(22) Date of filing: 24.09.1992
(51) Int. Cl.: H01L 31/0224, H01L 31/075, H01L 31/18, H01L 31/20

(54) **Photovoltaic device**
Photovoltaische Vorrichtung
Dispositif photovoltaique

(30) Priority: 25.09.1991 JP 245803/91; 12.12.1991 JP 351521/91
(43) Date of publication of application: 31.03.1993
(73) Proprietor: CANON KABUSHIKI KAISHA, Tokyo (JP)
(72) Inventor: Saito, Keishi, c/o Canon Kabushiki Kaisha, Tokyo (JP); Aoike, Tatsuyuki, c/o Canon Kabushiki Kaisha, Tokyo (JP)
(74) Representative: Pellmann, Hans-Bernd, Dipl.-Ing.

(56) References cited:
- DE-A- 3 438 437
- DE-A- 3 718 789
- JP-A- 2 219 281
- JP-A- 2 219 282
- US-A- 5 085 711
- PATENT ABSTRACTS OF JAPAN vol. 15, no. 233 (E-1077) 14 June 1991 & JP-A-03 070 184 (SANYO ELECTRIC CO LTD) 26 March 1991
- PATENT ABSTRACTS OF JAPAN vol. 3, no. 153 (E-159)15 December 1979 & JP-A-54 134 396 (AGENCY OF INDUSTRIAL SCIENCE AND TECHNOL) 18 October 1979
- TECHNICAL DIGEST OF THE INTERNATIONAL PVSEC-5 26 November 1990 , KYOTO,JP pages 367 - 370 ASHIDA ET AL. 'IMPROVEMENT OF INTERFACE PROPERTIES OF TCO/p-LAYER IN PIN-TYPE AMORPHOUS SILICON SOLAR CELLS'
- TECHNICAL DIGEST OF THE INTERNATIONAL PVSEC-5 26 November 1990 , KYOTO, JP pages 253 - 256 LEBLANC ET AL. 'OPTICAL ABSORPTION OF TRANSPARENT CONDUCTING OXIDES AND POWER DISSIPATION IN a-Si:H p-i-n SOLAR CELLS MEASURED BY PHOTOTHERMAL DEFLECTION SPECTROSCOPY'
- PATENT ABSTRACTS OF JAPAN vol. 010, no. 069 (E-389)18 March 1986 & JP-A-60 218 879 (HANDOUTAI ENERUGII KENKYUSHO:KK) 1 November 1985
- PATENT ABSTRACTS OF JAPAN vol. 013, no. 226 (E-763)25 May 1989 & JP-A-01 033 974 (FUJITSU LTD) 3 February 1989
- DATABASE WPI Week 9308, Derwent Publications Ltd., London, GB; AN 93-063558 & JP-A-5 013 792 (CANON KK) 22 January 1993

## Description

The present invention relates to a photovoltaic device for use in a solar battery, a photosensor, or the like, the photovoltaic device being constituted by stacking a semiconductor layer made of non-single-crystal semiconductor material, which contains silicon atoms, and a transparent electrode made of an indium oxide, a tin oxide, an indium-tin oxide or the like. More particularly, the present invention relates to a photovoltaic device made of amorphous silicon type semiconductor material (fine crystal silicon type semiconductor material included) or polycrystal silicon type semiconductor material as the non-single-crystal semiconductor material.

### Related Background Art

A transparent electrode is an important component which relates to the performance of a photovoltaic device. Hitherto, the transparent electrode has been made of an indium oxide, a tin oxide, or an indium-tin oxide while being formed into a film like shape formed by stacking the employed material by a spray method, the vacuum evaporating method, the ion plating method, the sputtering method or the like.

The light transmissivity and the specific resistance of the transparent electrode, thus stacked, are parameters which directly relate to the performance of the photovoltaic device. Also conditions under which the transparent electrode is stacked, for example, the temperature of the substrate, the degree of vacuum, the deposition speed and the like are important parameters which affect the quality of the semiconductor layer which is positioned adjacent to the transparent electrode.

Results of the study of the relationship between the photovoltaic device and the transparent electrode has been recently disclosed in "Optical absorption of transparent conducting oxides and power dissipation in a-Si:H pin solar cells measured by photothermal deflection spectroscopy" F. Leblanc, J. Perrin et al. Technical digest of the international PVSEC-5, Kyoto, Japan, 1990, 253, and "Improvement of interface properties of TCO/p-layer in pin-type amorphous silicon solar cells" Y. Ashida, N. Ishida, N. Ishiguro et al. Technical digest of the international PVSEC-5, Kyoto, Japan, 1990, 367.

Furthermore, technology capable of reducing the resistance of the transparent electrode by stacking an indium oxide film and a tin oxide film has been disclosed in Japanese Laid-Open Patent Application No. 54-134396.

However, there is a desire of further reducing the resistance of the conventional transparent electrode composed of the indium oxide, the tin oxide or the indium-tin oxide.

Furthermore, the transmissivity, the photovoltaic force and the photoelectric current must be further improved.

Since the photovoltaic device has been widely used recently, the photovoltaic device has been used in a variety of conditions, causing a separation to take place between the transparent electrode and the layer which is positioned in contact with the transparent layer depending upon the condition of use.

In addition, another problem of a short circuit arises due to a fact that the photovoltaic device is repeatedly subjected to a heat cycle for an excessively long time.

JP-A-60 218 879 discloses a photoelectric conversion device provided with a substrate or a first electrode on a substrate, a non-monocrystalline semiconductor having at least a PIN junction on said electrode, and a second electrode on said semiconductor, wherein an intrinsic or substantially intrinsic semiconductor layer constituting said PIN junction contains oxygen or nitrogen with a concentration not exceeding 5 x 10¹⁸ cm⁻³ and also contains an alkali metal element such as lithium.

JP-A-1 033 974 discloses an amorphous silicon photodiode comprising a structure in which a transparent electrode film consisting of an indium tin oxide film containing nitrogen and an amorphous silicon film are in contact.

Moreover DE-A-37 18 789 discloses a transparent conducting film consisting essentially of indium, oxygen and carbon.

In addition, JP-A-2219281 and JP-A-2219282 corresponding to US-A-5 085 711 published on 04.02.92 disclose a photovoltaic device comprising a substrate, a light-receiving-side tin oxide electrode, a p-type layer, a photo-active layer, a n-type layer and a back-electrode, which are subsequently formed on the substrate. The light-receiving-side electrode is doped with nitrogen in order to accelerate crystallization of the semiconductor film. In particular, a doping profile of nitrogen where this element is contained in larger quantities in a portion adjacent to the semiconductor layer is disclosed.

### SUMMARY OF THE INVENTION

An object of the present invention is to overcome the aforementioned problems experienced with the conventional photovoltaic device.

Another object of the present invention is to provide a photovoltaic device having a transparent electrode freed from distortion and exhibiting large photovoltaic force and photoelectric current.

Another object of the present invention is to provide a photovoltaic device having a uniform non-single-crystal semiconductor layer, which is deposited on a transparent electrode thereof, and which can be freed from abnormal deposition.

Another object of the present invention is to provide a photovoltaic device exhibiting stable characteristics.

Another object of the present invention is to provide a photovoltaic device which can be freed from separations of layers thereof because the structural distortion between the transparent electrode thereof and the semiconductor layer adjacent to the transparent electrode can be prevented considerably.

Another object of the present invention is to provide a photovoltaic device which can be manufactured while revealing a satisfactory manufacturing yield.

As a result of a study to overcome the aforementioned problems and to achieve the aforementioned objects, the following optimum structure was found.

Therefore, according to the present invention, there is provided a photovoltaic device having a conductive member on which semiconductor layers composed of a p-type layer, an i-type layer and an n-type layer made of non-single-crystal silicon-based semiconductor materials are stacked, and also having a transparent electrode stacked on the semiconductor layers, wherein the transparent electrode is made of an oxide selected from an indium oxide, a tin oxide or an indium-tin oxide which contains carbon atoms, and the carbon atoms are contained in the transparent electrode in the portion adjacent to the semiconductor layer in a larger quantity than those distributed in a portion of the same opposite to the semiconductor layer.

Further aspects of the present invention are set for thin independent claims 8 and 14.

The operation of the present invention will now be described while describing its detailed structure.

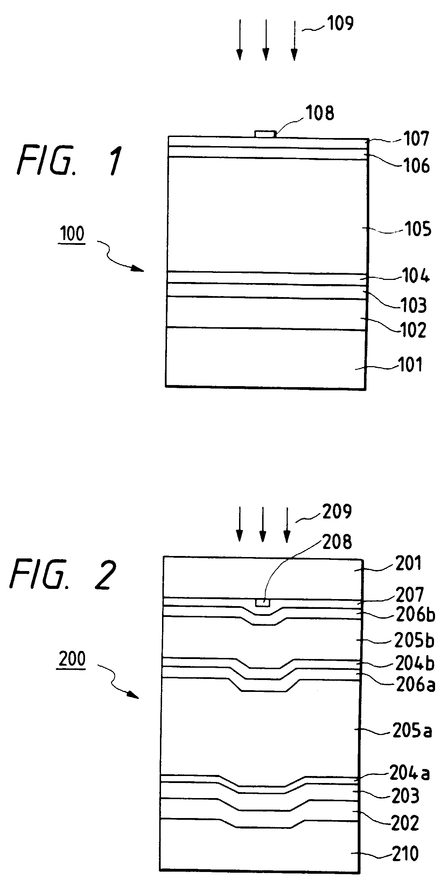

Figs. 1 and 2 are schematic views which illustrate photovoltaic devices 100, 200 according to the present invention.

The photovoltaic device 100 according to the present invention is, as shown in Fig. 1, composed of an opaque and conductive substrate 101 having, on the upper surface thereof, a light reflective (conductive) layer 102, a reflection promoting layer 103, an n- or p-type non-single-crystal silicon semiconductor layer 104, an i-type (substantially intrinsic) non-single-crystal silicon semiconductor layer 105, a p- or n-type non-single-crystal silicon semiconductor layer 106, a transparent electrode containing carbon atoms, or nitrogen atoms, or carbon and nitrogen atoms by a relatively larger quantity in the portion adjacent to the semiconductor layer, and a current collecting electrode 108. The photovoltaic device, thus constituted, is irradiated with irradiation light 109 emitted from above the transparent electrode 107.

The photovoltaic device 200 according to the present invention and shown in Fig. 2 is formed into a tandem structure composed of a transparent substrate 201 having, on the upper surface thereof, a current collecting electrode 208, a transparent electrode 207 containing carbon atoms, or nitrogen atoms, or carbon and nitrogen atoms by a relatively larger quantity in the portion adjacent to the semiconductor layer, a p- or n-type non-single-crystal silicon semiconductor layer 206b, an i-type (substantially intrinsic) non-single-crystal silicon semiconductor layer 205b, an n- or p-type silicon semiconductor layer 204b, a p- or n-type non-single-crystal silicon semiconductor layer 206a, an i-type (substantially intrinsic) non-single-crystal non-single-crystal silicon layer 205a, an n- or p-type silicon semiconductor layer 204a, a reflecting promoting layer 203, a light reflective (conductive) layer 202, and a conductive (and/or protection) layer 210. The photovoltaic device 200, thus constituted, is irradiated with irradiation light 209 emitted from above the transparent substrate 201.

Furthermore, a triple-type photovoltaic device formed by stacking pin units to form three layers is also adaptable to the present invention, although omitted from illustration.

### Transparent Electrode

The photovoltaic device according to the present invention has the transparent electrode in which carbon atoms, or nitrogen atoms, or carbon and nitrogen atoms are contained by a tin oxide, an indium oxide or an indium-tin oxide.

The transparent electrode, in which carbon atoms, or nitrogen atoms, or carbon and nitrogen atoms are contained by a tin oxide, an indium oxide or an indium-tin oxide, has characteristics that the crystal particle size of the oxide, which constitutes the transparent electrode, is enlarged, and dispersion of the crystal particle size is reduced. Furthermore, the arrangement in which the carbon atoms or the nitrogen atoms are contained in the transparent electrode will prevent distortion of the transparent electrode. As a result, the specific resistance of the transparent electrode can be reduced and as well as the transmissivity of the transparent electrode can be improved.

Furthermore, the fact that the transparent electrode contain the carbon atoms or the nitrogen atoms will smooth the shape of the crystal of the aforementioned oxide which forms the transparent electrode, causing an effect to be obtained in that the surface property (for example, the smoothness) of the transparent electrode can be improved. In particular, in a case where the transparent electrode is stacked on the semiconductor layer, the distortion between the semiconductor layer and the transparent electrode can be reduced, causing the adhesion between them to be significantly to be improved. In addition, another effect can be obtained in that abnormal deposition of the non-single-crystal silicon semiconductor layer can be reduced in a case where the non-single-crystal silicon semiconductor layer is stacked on the transparent electrode. Hence, even if a thin p- or n-type layer is deposited, an electric leak can be reduced. Therefore, average characteristics of the photovoltaic device can be improved.

Furthermore, since a relatively larger quantity of the carbon or nitrogen atoms is distributed on the portion of the transparent electrode adjacent to the semiconductor layer, the structural distortion due to the difference in the material between the transparent electrode and the semiconductor layer can be reduced.

It is preferable that the distribution of the carbon atoms or the nitrogen atoms contained by the transparent electrode be decreased in an exponential function manner from a position adjacent to the boundary between the transparent electrode and the semiconductor layer toward the inside portion of the transparent electrode. The fact that the carbon atoms or the nitrogen atoms in the transparent electrode are decreased in the exponential function manner will further reduce the structural distortion due to the difference in the material between the transparent electrode and the semiconductor layer. Furthermore, the character change due to the dispersion of the carbon atoms or the nitrogen atoms with time can be minimized.

It is preferable that the range in which the carbon atoms or the nitrogen atoms are distributed in the exponential function manner be ranged from 3 nm to 50 nm.

In the transparent electrode according to the present invention in which the carbon atoms or the nitrogen atoms, it can be considered that the temperature at which a satisfactory quality transparent electrode can be formed is lowered since the carbon atoms relate to the growth of the crystal of the oxide, although the detail has not be cleared yet. Therefore, excellent characteristics can be obtained even if the temperature is relatively low level.

The transparent electrode containing the carbon atoms or the nitrogen atoms and according to the present invention is deposited as follows.

An optimum deposition method is the sputtering method or the vacuum evaporation method to deposit the transparent electrode containing the carbon atoms or the nitrogen atoms and according to the present invention.

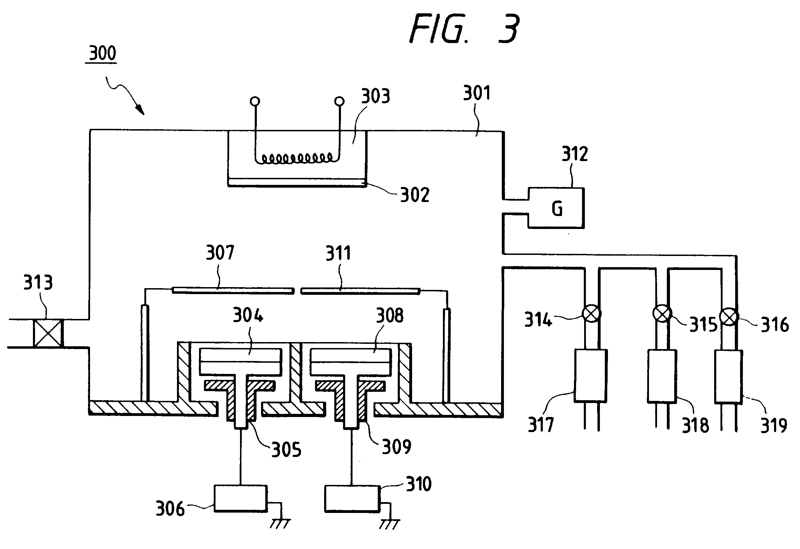

Furthermore, a DC magnetron sputtering apparatus 300 schematically shown in Fig. 3 is exemplified by a sputtering apparatus suitable to deposit the transparent electrode containing the carbon atoms or the nitrogen atoms and according to the present invention.

The DC magnetron sputtering apparatus 300 schematically shown in Fig. 3 and suitable to deposit the transparent electrode containing the carbon atoms or the nitrogen atoms and according to the present invention is composed of a deposition chamber 301, a substrate 302, a heater 303, targets 304 and 308, insulating supporting members 305 and 309, DC power sources 306 and 310, shutters 307 and 311, a vacuum meter 312, a conductance valve 313, gas introduction valves 314, 315 and 316, mass flow controllers 317, 318 and 319 or the like.

In a case where the transparent electrode made of a tin oxide containing the carbon atoms or the nitrogen atoms and according to the present invention is deposited on a substrate by using the DC magnetron sputtering apparatus 300, a target is made in such a manner that carbon atoms or nitrogen atoms are contained by metal tin (Sn) or a tin oxide (SnO₂).

In a case where the transparent electrode according to the present invention and made of an indium oxide containing carbon atoms or nitrogen atoms is deposited on a substrate, a target is made in such a manner that a material which contains carbon atoms or nitrogen atoms are contained by metal indium (In) or an indium oxide (In₃O₃).

In a case where the transparent electrode according to the present invention which is made of the indium-tin oxide containing carbon atoms or nitrogen atoms is deposited on a substrate, a target is made by properly combining metal tin, metal indium, a metal tin-metal indium alloy, a tin oxide, an indium oxide, and an indium-tin oxide which contain carbon atoms or nitrogen atoms. If an arrangement is made in such a manner that a plurality of targets having different carbon or nitrogen atom contents are prepared and the aperture ratio of a shutter which corresponds to the target can be changed, the distribution of the content of the carbon or nitrogen atoms in the transparent electrode can be changed.

As a starting material for generating carbon atoms to be contained by the target, graphite carbon or diamond-shape carbon is suitable.

In a case where the transparent electrode according to the present invention is deposited by a reactive sputtering method, the following process can be employed in which the aforementioned target and/or the target, which does not contain carbon atoms or nitrogen atoms, are properly combined so that a sputter target is prepared before a raw material gas containing carbon atoms or nitrogen atoms are introduced into a deposition chamber in which the carbon atoms or the nitrogen atoms are introduced into the transparent electrode by utilizing plasma energy. In this case, the distribution of the quantity of the carbon atoms or the nitrogen atoms introduced into the transparent electrode can be made arbitrary by changing the quantity of the raw material gas which contains the carbon atoms or the nitrogen atoms to be introduced into the deposition chamber.

The raw material gas containing carbon atoms which can be preferably adapted to the reactive sputtering method is exemplified by CH₄, CD₄, CₙH₂ₙ₊₂ (n is an integer), CₙH₂ₙ (n is an integer), C₂H₂, C₆H₆, CO₂, CO, and the like.

As the raw material gas containing nitrogen atoms which can be preferably adapted to the reactive sputtering method, N₂, NH₃, ND₃, NO, NO₂, N₂O and the like are exemplified.

It is preferable to make the maximum distribution density of carbon atoms or of each of said carbon atoms and nitrogen atoms contained in the transparent electrode according to the present invention to be ranged from 5 ppm or more to 1000 ppm or less. Furthermore, it is preferable that the maximum quantity of carbon atoms or nitrogen atoms to be contained in the aforementioned target in order to cause the carbon atoms or the nitrogen atoms to be contained by the transparent electrode to be distributed in the maximum distribution density range from 5 ppm or more to 1000 ppm or less be 1000 ppm or less although it considerably depends on the sputtering conditions.

In order to cause carbon atoms or nitrogen atoms to be contained by the transparent electrode by the maximum distribution density of 1000 ppm or less by the sputtering method, it is preferable that the maximum mixture ratio of the gas containing carbon atoms or nitrogen atoms to be mixed with the sputtering gas be about 2000 ppm or less.

In a case where the transparent electrode containing carbon atoms or nitrogen atoms is deposited by the sputtering method, the temperature of the substrate is an important factor and is exemplified by a range from 25°C to 600°C as a preferred range. In particular, the transparent electrode containing carbon atoms or nitrogen atoms, according to the present invention, exhibit excellent characteristics in comparison with the convention technology in a temperature range from 25°C to 250°C. Furthermore, the sputtering gas for use in the case where the transparent electrode containing carbon atoms or nitrogen atoms, according to the present invention, is deposited by the sputtering method is an inert gas exemplified by an argon (Ar) gas, a neon (Ne) gas, a xenon (Xe) gas, a helium (He) gas or the like. In particular, it is most preferable to employ the Ar gas. In addition, it is preferable to add an oxygen (O₂) gas to the inert gas if necessary. In particular, the oxygen (O₂) gas is required in the case where metal is made to be the target.

In the case where the target is sputtered by the inert gas or the like, it is preferable to make the pressure in the discharge space to be ranged from 0.1 to 50 mtorr (1 Torr = 133.32 Pa) in order to effectively perform the sputtering operation.

In addition, a DC or an RF power supply is exemplified as a preferred power source to be employed in the sputtering method. A preferred electric power is 10 to 1000W at the time of performing the sputtering method.

An optimum deposition speed at which the transparent electrode containing carbon atoms or nitrogen atoms, according to the present invention, is ranged from 0.01 to 10 nm/sec although it depends upon the pressure and the discharged electric power in the discharge space.

The second method adaptable to depositing the transparent electrode containing carbon atoms or nitrogen atoms, according to the present invention, is the vacuum evaporation method.

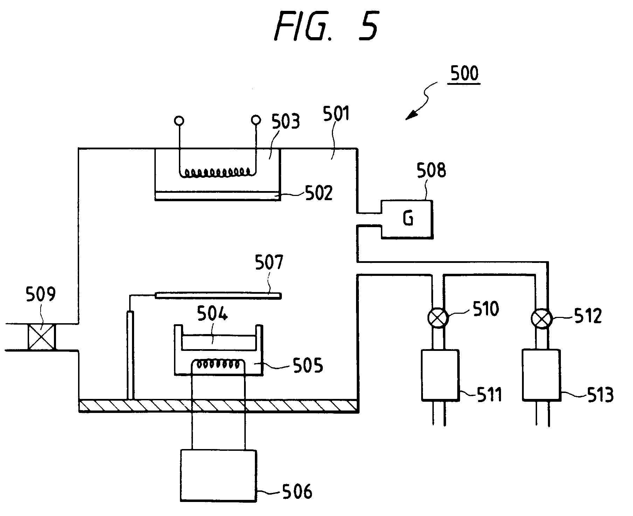

A vacuum evaporation apparatus 500 is, as schematically shown in Fig. 5, composed of a deposition chamber 501, a substrate 502, a heater 503, an evaporation source 504, a conductance valve 509 and a gas introduction valve 510 or the like.

As a preferred evaporation soufce to be employed at the time of depositing the transparent electrode containing carbon atoms or nitrogen atoms, according to the present invention, a material prepared by adding carbon atoms or nitrogen atoms to metal tin, or metal indium or the indium-tin alloy is exemplified. It is preferable to make the maximum content of carbon atoms or nitrogen atoms to be contained to be 1000 ppm or less.

It is preferable that the temperature of the substrate at the time of depositing the transparent electrode containing carbon atoms or nitrogen atoms, according to the present invention, be ranged from 25°C to 600°C.

In the case where the transparent electrode containing carbon atoms or nitrogen atoms, according to the present invention, is deposited, it is preferable to introduce the oxygen (O₂) gas to be introduced to have a pressure of 5 x 10⁻⁵ Torr to 9 x 10⁻⁴ torr after the pressure in the deposition chamber has been lowered to a level of 10⁻⁶ Torr or lower.

By introducing oxygen in the aforementioned range, the above mentioned metal gasified from the evaporation source reacts with oxygen in the gas phase so that an excellent transparent electrode can be deposited.

In the case where the transparent electrode containing carbon atoms or nitrogen atoms, according to the present invention, is deposited by the reactive evaporation, the transparent electrode may be deposited by evaporating the evaporation source and/or the other evaporation source which does not contain the carbon atoms or nitrogen atoms, in a state where the gas containing carbon atoms or nitrogen atoms has been introduced into the deposition chamber to a pressure lower than 5 x 10⁻⁴ Torr or lower. In addition, a process may be employed in which RF electric power is introduced at the aforementioned degree of vacuum to generate plasma and the evaporation is performed via the plasma thus generated. By changing, with time, the quantity of the gas containing carbon atoms or nitrogen atoms to be introduced into the deposition chamber, the distribution of the quantity of carbon atoms or nitrogen atoms to be contained in the transparent electrode can be arbitrarily changed. Also by changing the speed at which the evaporation source is evaporated while making the quantity of the gas containing carbon atoms or nitrogen atoms to be introduced into the deposition chamber to be constant, the distribution of the quantity of carbon atoms or nitrogen atoms to be contained in the transparent electrode can be arbitrarily changed.

It is preferable to make the speed at which the transparent electrode is deposited under the aforementioned conditions be 0.01 to 10 nm/sec. If the deposition speed is lower than 0.01 nm/sec, the manufacturing yield will deteriorate. If it is higher than 10 nm/sec, a rough film is undesirably formed, causing the transmissivity, the conductivity and the adhesion to deteriorate.

The preferred thickness of the transparent electrode, which contains carbon atoms or nitrogen atoms, of the photovoltaic device according to the present invention is a thickness with which the conditions required for the reflection prevention film can be met. Specifically, it is preferable that the thickness of the transparent electrode be ranged from 50 nm to 300 nm.

By causing carbon atoms to be simultaneously contained by the transparent electrode which contains nitrogen atoms, the characteristics of the photovolatic device can be further improved.

By causing nitrogen atoms and carbon atoms to be simultaneously contained by the transparent electrode, the durability against the heat cycle to which the photovoltaic device according to the present invention is subjected can be further improved. In addition, the flexibility of the transparent electrode can be further improved, causing cracks of the photovoltaic device to be prevented.

It is preferable to make the quantity of carbon atoms to be, as well as the addition of the nitrogen atoms, added to the transparent electrode of the photovoltaic device according to the present invention to be 100 ppm or less.

Such carbon atoms are introduced into the transparent electrode by the same means and method as those employed when nitrogen atoms are introduced.

By using the target and the evaporation source which contain carbon atoms at the time of performing sputtering or the vacuum evaporation for the purpose of depositing the transparent electrode, the transparent electrode may contain carbon atoms. It is preferable that graphite-form carbon or diamond-form carbon is used as the starting material for generating carbon to be contained by the target and the evaporation source.

In the case where the transparent electrode containing nitrogen atoms and carbon atoms, according to the present invention, is deposited by the reactive sputtering method, the following process may be employed: the aforementioned target and/or the target which does not contain carbon atoms are arbitrarily combined so that the sputtering target is obtained, the raw material gas containing carbon atoms is, in addition to the aforementioned raw material gas containing nitrogen atoms, introduced into the deposition chamber, and plasma energy is utilized, so that carbon atoms may be introduced into the transparent electrode as well as adding nitrogen atoms.

The raw material gas containing carbon atoms adaptable to the reactive sputtering may be made of a material exemplified by CH₄, CD₄, CₙH₂ₙ₊₂ (n is an integer), CₙH₂ₙ (n is an integer), C₂H₂, C₆H₆, CO₂, CO or the like.

In the case where the transparent electrode containing carbon atoms as well as nitrogen atoms, according to the present invention, is deposited by the reactive evaporation, the evaporation source and/or the evaporation source which does not contain carbon atoms are evaporated in a state where the gas containing carbon atoms has been introduced into the deposition chamber to a pressure level of 5 x 10⁻⁴ Torr or less so that the transparent electrode is deposited. Furthermore, a process may be employed in which RF electric power is introduced at the aforementioned degree of vacuum so as to generate plasma, and the evaporation may be performed via the plasma thus generated.

### p-type layer or n-type layer

The p- or n-type layer of the photovolatic device according to the present invention is an important layer which influences the characteristics of the photovoltaic device.

The amorphous material (hereinafter expressed as "a-") and the fine crystal material (hereinafter expressed as "µc-") of the p- or the n-type layer of the photovolatic device according to the present invention are exemplified by: material prepared by adding, by a high density, a p-type valence controlling agent (B, Al, Ga, In or Tl of group III of the periodic table) or an n-type valence controlling agent (P, As, Sb and Bi of group V of the periodic table) to a-Si:H, a-Si:HX, a-SiC:H, a-SiC:HX, a-SiGe:H, a-SiGeC:H, a-SiO:H, a-SiN:H, a-SiON:HX, a-SiOCN:HX, µc-Si:H, µc-SiC:H, µc-Si:HX, µc-SiC:HX, µc-SiGe:H, µc-SiO:H, µc-SiGe:H, µc-SiN:H, µc-SiON:HX, µc-SiOCN:HX, or the like. As the polycrystal material (hereinafter called as "poly-") is exemplified by a material prepared by adding, by a high density, a p-type valence controlling agent (B, Al, Ga, In or Tl of group III of the periodic table) or an n-type valence controlling agent (P, As, Sb or Bi of group V of the periodic table) to poly-Si:H, poly-Si:HX, poly-SiC:H, poly-SiC:HX, poly-SiGe:H, poly-Si, poly-SiC, poly-SiGe, or the like.

In particular, it is preferable that the p-type layer or the n-type layer on which light is incident be made of a crystalline semiconductor layer which reveals small light absorption or with an amorphous semiconductor layer having a wide band gap.

It is preferable to make the quantity of addition of any one of the atoms of group III of the periodic table to the p-type layer and that of addition of any one of the atoms of group V of the periodic table to the n-type layer to be 0.1 to 50 atom%.

Hydrogen atoms (H, D) or halogen atoms contained by the p-type layer or the n-type layer act to compensate the non-bonded hard of the p- or n-type layer, causing the doping efficiency into the p- or n-type layer to be improved. The optimum quantity of hydrogen atoms to be added to the p- or n-type layer is 0.1 to 40 atom%. In a case where the p- or the n-type layer is crystalline in particular, the optimum quantity of hydrogen atoms or halogen atoms is 0.1 to 8 atom%. Furthermore, it is preferable that the distribution be made in such a manner that a large quantity of hydrogen atoms and/or that of halogen atoms are distributed in a portion adjacent to the boundary between the p-type layer and the i-type layer and that between the n-type layer and the i-type layer. In addition, it is preferable that quantity of hydrogen atoms and/or halogen atoms distributed adjacent to the aforementioned boundaries be ranged from 1.1 to 2 times the quantity of the same in the bulk. By causing hydrogen atoms or halogen atoms to be contained by a larger quantity in the portion adjacent to the boundaries between the p-type layer and the i-type layer and between the n-type layer and the i-type layer, defective levels or mechanical distortions which may take place adjacent to the aforementioned boundaries can be reduced. Therefore, the photovoltaic force and the optical electric current of the photovoltaic device according to the present invention can be enlarged.

In addition, it is preferable that a large quantity of hydrogen atoms and/or that of halogen atoms are distributed adjacent to the boundary between the transparent electrode and the p-type layer or that between the transparent electrode and the n-type layer. In addition, it is preferable that quantity of hydrogen atoms and/or halogen atoms distributed adjacent to the aforementioned boundaries be ranged from 1.1 to 2 times the quantity of the same in the bulk. By causing hydrogen atoms or halogen atoms to be contained by a larger quantity in the portion adjacent to the boundaries between the transparent electrode and the p-type layer or that between the transparent electrode and the n-type layer, defective levels or mechanical distortions which may take place adjacent to the aforementioned boundaries can be reduced. Therefore, the photovoltaic force and the optical electric current of the photovoltaic device according to the present invention can be enlarged.

It is preferable that the activating energy among the electric characteristics of the p- or n-type layer of the photovoltaic device according to the present invention be 0.2 eV or less, more preferably 0.1 eV or less. Furthermore, it is preferable that the specific resistance be 100 Ωcm or less, more preferably 1 Ωcm or less. In addition, it is preferable that the thickness of each of the p-type and the n-type layer be 1 to 50 nm, more preferable 3 to 10 nm.

As the raw material gas for suitably use to deposit the p-type or n-type layer of the photovoltaic device according to the present invention, a compound which contains silicon atoms and which can be gasified, a compound which contains germanium atoms and which can be gasified, a compound which contains nitrogen atoms and which can be gasified and a mixture gas of the aforementioned compounds.

Specifically, the compound which contains silicon atoms and which can be gasified is exemplified by SiH₄, SiH₆, SiF₄, SiFH₃, SiF₂H₂, SiF₃H, Si₃H₈, SiD₄, SiHD₃, SiH₂D₂, SiH₃D, SiFD₃, SiF₂D₂, SiD₃H, Si₂D₃H₃ or the like.

The compound which contains germanium atoms and which can be gasified is exemplified by GeH₄, GeD₄, GeF₄, GeFH₃, GeF₂H₂, GeF₃H, GeHD₃, GeH₂D₂, GeH₃D, GeH₆, GeD₆ or the like.

The compound which contains carbon atoms and which can be gasified is exemplified by CH₄, CD₄, CₙH₂ₙ₊₂ (n is an integer), CₙH₂ₙ (n is an integer), C₂H₂, C₆H₆, CO₂, CO or the like.

The gas containing nitrogen is exemplified by N₂, NH₃, ND₃, NO, NO₂, N₂O or the like.

The gas containing oxygen is exemplified by O₂, CO, CO₂, NO, NO₂, N₂O, CH₃CH₂OH, CH₃OH or the like.

The material to be introduced into the p-type or n-type layer for the purpose of controlling the valence electrons is exemplified by atoms of group III or V of the periodic table.

As an effective starting material for introducing the boron atoms of group III, a boron hydride such as B₂H₆, B₄H₁₀, B₅H₉, B₅H₁₁, B₆H₁₀, B₆H₁₂, B₆H₁₄ or the like, and halogen hydrides such as BF₃, BCl₃ or the like are exemplified. Also AlCl₃, GaCl₃, InCl₃, TlCl₃ or the like are exemplified. In particular, B₂H₆ and BF₃ are suitable for use.

As an effective starting material for introducing the phosphorus atoms of group V, a phosphorus hydride such as PH_{3,} P₂H₄ or the like, and halogen hydride such as PH₄I, PF_{3,} PF₅, PCl_{3,} PCl₅, PBr₃, PBr₅, PI₃ or the like are exemplified. Also AsH₃, AsF₃, AsCl₃, AsBr₃, AsF₅, SbH₃, SbF₃, SbF₅, SbCl₃, SbCl₅, BiH₃, BiCl₃, BiBr₃ or the like are exemplified. In particular, PH₃ and PF₃ are suitable for use.

The P- or n-type layer of the photovoltaic device according to the present invention can be preferably deposited by an RF plasma CVD method or a µW plasma CVD method.

In a case where the RF plasma CVD method is employed to deposit the aforementioned layer in particular, a capacity coupled type RF plasma CVD method is suitable for use.

In a case where the p- or n-type layer is deposited by the RF plasma CVD method, the optimum conditions are as follows: the temperature of the substrate in the deposition chamber is 100 to 350°C, the internal pressure is 0.1 to 10 torr, the RF power is 0.05 to 1.0 W/cm² and the deposition speed is 0.01 to 3 nm/sec.

The compound which can be gasified may be properly diluted with H₂, He, Ne, Ar, Xe, Kr gas or the like before it is introduced into the deposition chamber.

In the case where the layer which is made of the fine crystal semiconductor and which does not absorb light considerably or the layer having a wide band gap is deposited in particular, it is preferable to dilute the raw material with a hydrogen gas to 2 to 100 times and to introduce relatively large RF power. The preferred RF frequency is 1 MHz to 100 MHz, more preferably, a frequency near 13.56 MHz.

In a case where the p- or n-type layer suitable for the present invention is deposited by the µW plasma CVD method, it is preferable to constitute the µW plasma CVD apparatus in such a manner that microwaves are introduced into the deposition chamber through a wave guide pipe via a dielectric window (made of alumina ceramics or the like).

In the case where the p- or n-type layer suitable for the present invention is deposited by the µW plasma CVD method, it is preferable that the temperature of the substrate in the deposition chamber be 100 to 400°C, the internal pressure be 0.5 to 30 mTorr, the µW power be 0.01 to 1 W/cm³, and the frequency of µW be 0.5 to 10 GHz.

Furthermore, the aforementioned compound which can be gasified may be diluted with H₂, He, Ne, Ar, Xe, Kr gas or the like before it is introduced into the deposition chamber.

In the case where a fine crystal semiconductor, or a layer such as the a-SiC:H which does not considerably absorb light, or a layer which has a wide band gap is deposited in particular, it is preferable that the raw material gas be diluted with a hydrogen gas to 2 to 100 times and as well as relative large µw power be introduced.

### i-type layer

The i-type layer of the photovoltaic device according to the present invention is an important layer for generating and transporting the carrier when it is irradiated with light.

As the i-type layer of the photovoltaic device according to the present invention, a slightly p-type layer or a slightly n-type layer may be used. In a case where a semiconductor layer is used in which the product of the mobility of the positive holes and the life is smaller than the product of the mobility of electrons and the life is used, it is suitable to employ the slightly p-type. In a case where a semiconductor layer is used in which the product of the mobility of electrons and the life is smaller than the product of the mobility of the positive holes and the life is used, it is suitable to employ the slightly n-type layer.

The material for the i-type layer of the photovoltaic device according to the present invention is exemplified by an amorphous (hereinafter called as "a-") material such as a-Si:H, a-Si:HX, a-SiC:H, a-SiC:HX, a-SiGe:H, a-SiGe:HX, a-SiGeC:HX or the like.

In particular, it is preferable to use a material caused to be an intrinsic type by adding, as a valence controlling agent, atoms of group III and/or atoms of group V of the periodic table to the aforementioned amorphous material.

Hydrogen atoms (H, D) or halogen atoms (X) contained by the i-type layer act to compensate the non-bonded hands of the i-type layer so as to cause the i-type layer to have an improved product of the mobility of the carrier and the life. It further acts to compensate the level of the boundaries between the p-type layer and the i-type layer and between the n-type layer and the i-type layer, causing an effect to be obtained in that the photovoltaic force, the photoelectric current and the light responsibility of the photovoltaic device are improved. It is preferable that hydrogen atoms and/or halogen atoms be contained by the i-type layer by 1 to 40 atom%. In particular, it is preferable that hydrogen atoms and/or halogen atoms be distributed by a larger quantity adjacent to the boundaries between the p-type layer and the i-type layer and between the n-type layer and the i-type layer. Furthermore, it is preferable to make the contents of hydrogen atoms and halogen atoms adjacent to the boundaries to be 1.1 to 2 times the contents in the bulk.

It is preferable that the thickness of the i-type layer be 0.1 to 1.0 µm although it considerably depends on the structure (for example, a single cell, a tandem cell or a triple cell) of the photovolatic device and the band gap of the i-type layer.

It is preferable that the basis physical properties of the i-type layer be made as follows: the mobility of electrons is 0.01 cm²/V/sec or more, the mobility of the positive holes is 0.0001 cm²/V/sec or more, the band gap is 1.1 to 2.2 eV, the local density at the center of the inhibited zone is 10¹⁸ cm³/eV or less, and the inclination of the perbacktail adjacent to the valence zone is 65 meV or less. Furthermore, it is preferable that the current-voltage characteristics of the photovoltaic device according to the present invention are measured under AM 1.5, 100 mW/cm², the curve fitting is performed by the Hecht method, the product of the mobility and the life obtained from the curve fitting is made to be 10⁻¹⁰ cm²/V or more.

It is preferable that the band gap of the i-type layer be widened adjacent to the boundaries between the p-type layer and the i-type layer and between the n-type layer and the i-type layer. In this case, the photovoltaic force and the photoelectric current of the photovoltaic device can be enlarged and as well as deterioration due to light after the photovoltaic device is used for a long time can be prevented.

A raw material gas suitable to deposit the i-type layer of the photovoltaic device according to the present invention is exemplified by a compound which contains silicon atoms and which can be gasified, a compound which contains germanium atoms and which can be gasified, a compound which contains carbon atoms and which can be gasified, a compound which contains nitrogen atoms and which can be gasified and a mixture gas of the aforementioned compounds.

Specifically, the compound which contains silicon atoms and which can be gasified is exemplified by SiH₄, SiH₆, SiF₄, SiFH₃, SiF₂H₂, SiF₃H, Si₃H₈, SiD₄, SiHD₃, SiH₂D₂, SiH₃D, SiFD₃, SiF₂D₂, SiD₃H, Si₂D₃H₃ or the like.

The compound which contains germanium atoms and which can be gasified is exemplified by GeH₄, GeD₄, GeF₄, GeFH₃, GeF₂H₂, GeF₃H, GeHD₃, GeH₂D₂, GeH₃D, GeH₆, GeD₆ or the like.

The compound which contains carbon atoms and which can be gasified is exemplified by CH₄, CD₄, CₙH₂ₙ₊₂ (n is an integer), CₙH₂ₙ (n is an integer), C₂H₂, C₆H₆ or the like.

The material to be introduced into the i-type layer for the purpose of controlling the valence electrons of the i-type layer according to the present invention is exemplified by atoms of group III and those of group V of the periodic table.

An effective starting material according to the present invention for introducing atoms of group III is exemplified by a boron hydride such as B₂H₆, B₄H₁₀, B₅H₉, B₅H₁₁, B₆H₁₀, B₆H₁₂, B₆H₁₄ or the like and halogen hydrides such as BF₃, BCl₃ or the like. Also AlCl₃, GaCl₃, InCl₃, TlCl₃ or the like are exemplified.

As an effective starting material for introducing the phosphorus atoms of group V, a phosphorus hydride such as PH₃, P₂H₄ or the like and halogen hydride such as PH₄I, PF₃, PF₅, PCl₃, PCl₅, PBr₃, PBr₅, PI₃ or the like are exemplified. Also AsH₃, AsF₃, AsCl₃, AsBr₃, AsF₅, SbH₃, SbF₃, SbF₅, SbCl₃, SbCl₅, BiH₃, BiCl₃, BiBr₃ or the like are exemplified.

It is preferable that the quantity of atoms of groups III and V of the periodic table to be introduced into the i-type layer for the purpose of controlling the conductivity be 1000 ppm or less.

The preferred method for depositing the i-type layer adaptable to the present invention is exemplified by the RE plasma CVD method and the µW plasma CVD method. In the case where the RF plasma CVD method is employed, it is preferable to use a capacity coupled type RF plasma CVD apparatus.

In the case where the i-type layer is deposited by the RF plasma CVD method, the optimum conditions are as follows: the temperature of the substrate in the deposition chamber is 100 to 350°C, the internal pressure is 0.1 to 10 torr, the RF power is 0.05 to 1.0 W/cm², and the deposition speed is 0.01 to 3 nm/sec.

Furthermore, the compound which can be gasified may be arbitrarily diluted with H₂, He, Ne, Ar, Xe, Kr gas or the like before it is introduced into the deposition chamber.

In the case where a layer such as the a-SiC:H having a wide band gap is deposited, it is preferable that the raw material gas be diluted with hydrogen gas to 2 to 100 times and as well as relatively large RF power be introduced. The preferred RF frequency is 1 MHz to 100 MHz, more preferably a frequency of about 13.56 MHz.

In the case where the i-type layer according to the present invention is deposited by the µW plasma CVD method, it is preferable to employ a method arranged in such a manner that microwaves are introduced into the deposition chamber through a wave guide pipe via a dielectric window (made of alumina ceramics or the like).

In the case where the i-type layer according to the present invention is deposited by the µW plasma CVD method, it is preferable that the temperature of the substrate in the deposition chamber be 100 to 400°C, the internal pressure be 0.5 to 30 mtorr, the µW power be 0.01 to 1 W/cm³ and the µW frequency be 0.5 to 10 GHz.

Furthermore, the compound which can be gasified may be arbitrarily diluted with H₂, He, Ne, Ar, Xe, Kr gas or the like before it is introduced into the deposition chamber.

In the case where a layer such as the a-SiC:H having a wide band gap is deposited, it is preferable that the raw material gas be diluted with hydrogen gas to 2 to 100 times and as well as relatively large RF power be introduced.

### Conductive Substrate

The conductive substrate may be made of conductive material, or a structure may be employed which is arranged in such a manner that a supporting member is formed by an insulating material or a conductive material and it is processed to have conductivity. The material for the conductive supporting member is exemplified by metal such as NiCr, stainless steel, Al, Cr, Mo, Au, Nb, Ta, V, Ti, Pt, Pb, Sn, or the like and their alloy.

The electrically insulating supporting member may be made of a synthetic resin film or a sheet, the material of which is exemplified by polyester, polyethylene, polycarbonate, cellulose acetate, polypropylene, polyvinyl chloride, polyvinylidene, polystyrene, polyamide and the like, glass, ceramic, paper and the like. It is preferable that the electrically insulating supporting member be manufactured in such a manner that the surface of at least its either side is subjected to a process for possessing conductivity and the photovoltaic layer is formed on the surface of aforementioned side.

In the case where glass is employed, a thin film made of NiCr, Al, Cr, Mo, Ir, Nb, Ta, V, Ti, Pt, Pb, IN₂O₃, ITO (IN₂O₃ + Sn), or the like is formed on the surface of the glass so as to have conductivity. In the case where the synthetic film made of the polyester film or the like is employed, a metal thin film made of NiCr, Al, Ag, Pb, Zn, Ni, Au, Cr, Mo, Ir, Nb, Ta, V, Tl, Pt, or the like is formed on the surface of the synthetic resin film by vacuum evaporation, electron beam evaporation, sputtering, or the like. As an alternative to this, the aforementioned surface is laminated with the aforementioned metal before it has conductivity. The supporting member may be formed into a sheet having a flat and smooth surface or having a wave surface. Although its thickness is determined so as to form a desired photovoltaic device, it may be thinned so far as the function of the supporting member can be exhibited in a case where the photovoltaic device requires flexibility. However, the thickness must 10 µm or more in usual so as to be easily manufactured and handled and to have satisfactory mechanical strength.

### BRIEF DESCRIPTION OF THE DRAWINGS

Fig. 1 is a schematic structural view which illustrates the structure of the layers of a photovoltaic device according to the present invention;
Fig. 2 is a schematic structural view which illustrates the structure of the layers of another photovoltaic device according to the present invention, wherein the device having a structure similar to that of a conventional photovoltaic device is illustrated;
Fig. 3 is a schematic view which illustrates an example of an apparatus for manufacturing a transparent electrode for the photovoltaic device according to the present invention, wherein a manufacturing apparatus adapted to a DC magnetron sputtering method is illustrated;
Fig. 4 is a schematic view which illustrates an example of an apparatus for manufacturing a non-single-crystal silicon semiconductor layer for the photovoltaic device according to the present invention, wherein a manufacturing apparatus adapted to a glow discharge method which uses µW is illustrated;
Fig. 5 is a schematic view which illustrates an example of an apparatus for manufacturing the transparent electrode for the photovoltaic device according to the present invention, wherein a manufacturing apparatus adapted to a vacuum evaporation method is illustrated; and
Fig. 6 is a schematic view which illustrates an example of an apparatus for manufacturing the non-single-crystal silicon semiconductor layer for the photovoltaic device according to the present invention, wherein a manufacturing apparatus which uses RF is illustrated.

### DETAILED DESCRIPTION OF THE PREFERRED EMBODIMENTS

Preferred embodiments of the present invention will now be described. However, the present invention is not limited to the descriptions made hereinafter.

### Example 1

A photovoltaic device according to the present invention was manufactured by a DC magnetron sputtering method and a microwave (hereinafter abbreviated to "µW") glow discharge decomposition method.

First, a transparent electrode, which contains carbon atoms, was formed on a substrate by the DC magnetron sputtering apparatus 300 shown in Fig. 3 and adapted to the DC magnetron sputtering method.

Referring to Fig. 3, reference numeral 302 represents the substrate made of barium borosilicate glass ("7059" manufactured by Coning K.K.) formed into a 50 mm x 50 mm square and having a thickness of 1 mm.

Referring to Fig. 3, reference numeral 304 represents a target composed of indium (In), tin (Sn) and carbon (C) contained by a molar ratio of 85:15:0.005, the target 304 being insulated from a deposition chamber 301 by an insulating supporting member 305.

Referring to Fig. 3, reference numeral 308 represents a target composed of indium (In) and tin (Sn) contained by a molar ratio of 85:15, the target 308 being insulated from the deposition chamber 301 by an insulating supporting member 309.

Referring to Fig. 3, reference numerals 314 and 315 represent gas introduction valves, each of which is connected to an oxygen (O₂) and an argon (Ar) gas cylinders (not shown).

First, the substrate 302 was heated to 350°C by a heater 303 and the inside the deposition chamber 301 was exhausted by a vacuum pump (not shown) until a vacuum meter 312 indicated a reading of about 1 x 10⁻⁵ Torr. At this time, the gas introduction valves 314 and 315 were gradually opened to introduce the O₂ gas and the Ar gas into the deposition chamber 301. In order to make the flow rate of the O₂ gas to be 20 sccm and the Ar gas to be 20 sccm at this time, corresponding mass-flow controllers 317 and 318 were used to control them. Furthermore, the opening of a (butterfly type) conductance valve 313 was adjusted while observing the vacuum meter 312 so as to make the pressure in the deposition chamber 301 to be 2 mtorr. Then, the voltage of a DC power source 306 was set to -400V and the DC power was supplied to the target 304, while the voltage of a DC power source 310 was set to -450V and the DC power was supplied to the target 308, causing DC glow discharge to take place. Then, shutters 307 and 311 were opened so that the process of manufacturing the transparent electrode on the substrate was commenced. Simultaneously, the voltage of the DC power source 310 was gradually changed from -450V to -350V at a predetermined rate until the transparent electrode which was 70 nm thick was formed. At this time, the shutters 307 and 311 were closed, and the outputs from the DC power sources 306 and 310 were shut so that the DC glow discharge was stopped. Then, the gas introduction valve 315 was closed so as to stop the introduction of the Ar gas into the deposition chamber 301. Furthermore, the opening of the conductance valve 313 was adjusted so as to make the internal pressure of the deposition chamber to be 1 Torr (1 Torr = 133.32 Pa), and the transparent electrode was subjected to a heat treatment for one hour, so that the transparent electrode containing carbon atoms was manufactured.

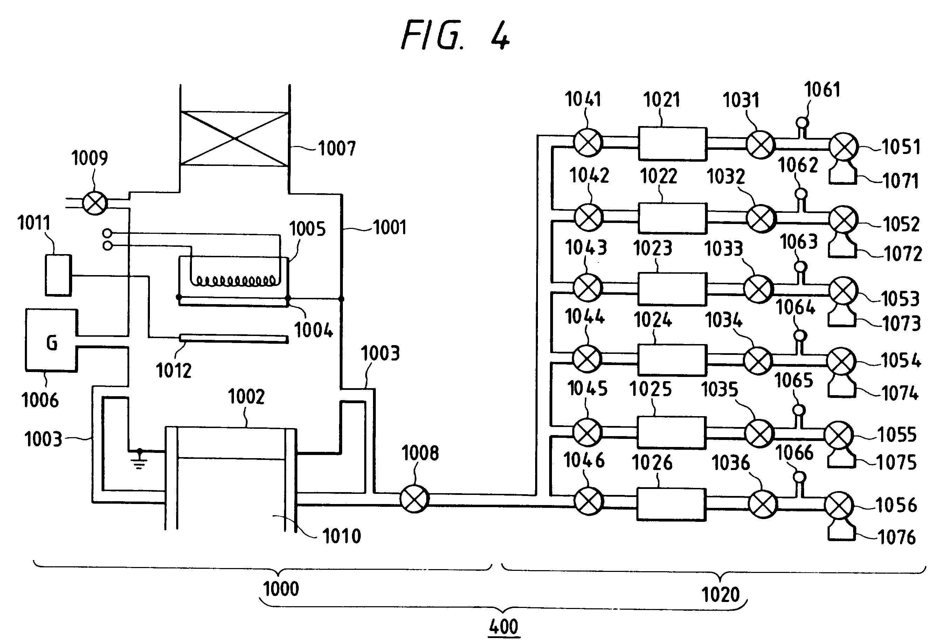

Then, a manufacturing apparatus 400 is, as shown in Fig. 4 and adapted to the µW glow discharge decomposition method, composed of a raw material gas supply apparatus 1020 and a deposition apparatus 1000 was used so that non-single-crystal silicon semiconductor layer was formed on the transparent electrode.

Referring to Fig. 4, gas cylinders 1071 to 1076 are filled with raw materials gases for manufacturing the non-single-crystal silicon semiconductor layer according to the present invention. Reference numeral 1071 represents a SiH₄ (purity was 99.999%) gas cylinder, 1072 represents a H₂ (purity was 99.9999%) gas cylinder, 1073 represents a cylinder for B₂H₆ gas (purity was 99.99% and hereinafter abbreviated to "B₂H₆/H₂") diluted with a H₂ gas to 10%, 1074 represents a cylinder for PH₃ gas (purity was 99.99% and hereinafter abbreviated to "PH₃/H₂") diluted with a H₂ gas to 10%, 1075 represents a CH₄ gas (purity was 99.9999%) cylinder, and 1076 represents a GeH₄ gas (purity was 99.99%) cylinder. When the cylinders 1071 to 1076 were installed, the aforementioned gases were previously introduced into the gas pipes from valves 1051 to 1056 to introduction valves 1031 to 1036.

Reference numeral 1004 represents a substrate on which the transparent electrode was formed by the aforementioned method.

First, the SiH₄ gas was introduced from the gas cylinder 1071, the H₂ gas was introduced from the gas cylinder 1072, the B₂H₆/H₂ gas was introduced from the gas cylinder 1073, the PH₃/H₂ gas was introduced from the gas cylinder 1074, the CH₄ gas was introduced from the gas cylinder 1075, and the GeH₄ gas was introduced from the gas cylinder 1076 by opening valves 1051 to 1056, and the pressure of each gas was made to be about 2 kg/cm² by pressure adjusters 1061 to 1066.

Then, facts that introduction valves 1031 to 1036 and a leak valve 1009 of a deposition chamber 1001 have been closed were confirmed, and as well as facts that discharge valves 1041 to 1046 and an auxiliary valve 1008 have been opened were confirmed, and then a (butterfly type) conductance valve 1007 was fully opened and the insides of the deposition chamber 1001 and the gas pipe were exhausted by a vacuum pump (not shown) until a vacuum meter 1006 indicated a reading of about 1 x 10⁻⁴ Torr. At this time, the auxiliary valve 1008 and the discharge valve 1041 to 1046 were closed.

Then, the discharge valves 1031 to 1036 were gradually opened so that the aforementioned gases were introduced into corresponding mass-flow controllers 1021 to 1026.

After preparations for forming the layers have been completed, the p-, the i- and the n-type layers were formed on the substrate 1004.

The p-type layer was formed in such a manner that the substrate 1004 was heated by a heater 1005 to 350°C, and the discharge valves 1041 to 1043 were gradually opened so that the SiH₄ gas, the H₂ gas and the B₂H₅/H₂ gas were introduced into the deposition chamber 1001 via an introduction pipe 1003. At this time, the corresponding mass-flow controllers 1021 to 1023 were used to make the flow rate of the SiH₄ gas to be 10 sccm, that of the H₂ gas to be 100 sccm and that of the B₂H₅/H₂ gas to be 5 sccm. In order to make the internal pressure of the deposition chamber 1001 to be 20 mtorr, the opening of the conductance valve 1007 was adjusted while observing the vacuum meter 1006. Then, the power of a µW power source (not shown) was set to 400 mW/cm³ and it was supplied to the inside of the deposition chamber 1001 via a wave-guide pipe (not shown), a wave-guide portion 1010 and a dielectric window 1002. As a result, µW glow discharge was caused to take place, so that the process of forming the p-type layer on the transparent electrode was commenced until the p-type layer which is 5 nm thick was formed. At this time, the µW glow discharge was stopped, and the discharge valves 1041 to 1043 and the auxiliary valve 1008 were closed so as to stop the introduction of the gases into the deposition chamber 1001. Thus, the process of forming the p-type layer was completed.

Then, the i-type layer was formed in such a manner that the substrate 1004 was heated to 350°C by the heater 1005, and the discharge valves 1041 and 1042 and the auxiliary valve 1008 were gradually opened so that the SiH₄ gas and the H₂ gas were introduced into the deposition chamber 1001 via the introduction pipe 1003. At this time, the corresponding mass-flow controllers 1021 and 1022 were used to make the flow rate of the SiH₄ gas to be 100 sccm and that of the H₂ gas to be 200 sccm. In order to make the internal pressure of the deposition chamber 1001 to be 5 mTorr, the opening of the conductance valve 1007 was adjusted while observing the vacuum meter 1006. Then, the high frequency bias of a bias power source was set to 100 mW/cm³ and the DC bias was set to 75V with respect to the substrate 1004 so as to be supplied to a bias rod 1012. Then, the power of the µW power source (not shown) was set to 100 mW/cm³ and it was supplied to the inside of the deposition chamber 1001 via the waveguide pipe (not shown), the wave-guide portion 1010 and the dielectric window 1002. As a result, µW glow discharge was caused to take place, so that the process of forming the i-type layer on the p-type layer was commenced until the i-type layer which was 400 nm thick was formed. At this time, the µW glow discharge was stopped, and the output of the bias power source was stopped. Thus, the process of forming the i-type layer was completed.

The n-type layer was formed in such a manner that the substrate 1004 was heated to 300°C by the heater 1005, and the discharge valve 1044 was gradually opened so that the SiH₄ gas, the H₂ gas and the PH₃/H₂ gas were introduced into the deposition chamber 1001 via the introduction pipe 1003. At this time, the corresponding mass-flow controllers 1021, 1022 and 1024 were used to make the flow rate of the SiH₄ gas to be 30 sccm, that of the H₂ gas to be 100 sccm and that of the PH₃/H₂ gas to be 6 sccm. In order to make the internal pressure of the deposition chamber 1001 to be 10 mtorr, the opening of the conductance valve 1007 was adjusted while observing the vacuum meter 1006. Then, the power of the µW power source (not shown) was set 50 mW/cm³ so as to be supplied to the inside of the deposition chamber 1001 via the wave-guide pipe (not shown), the wave-guide portion 1010 and the dielectric window 1002. As a result, µW glow discharge was caused to take place, so that the process of forming the n-type layer on the i-type layer was commenced until the n-type layer which was 10 nm thick was formed. At this time, the µW glow discharge was stopped, and the discharge valve 1041, 1042, 1044 and the auxiliary valve 1008 were closed so as to stop the introduction of the gases into the deposition chamber 1001. Thus, the process of forming the n-type layer was completed.

When each of the aforementioned layers was formed, the discharge valves 1041 to 1046 must, of course, be closed completely except for the valves for the required gases. Furthermore, the undesirable retentions of the gases in the deposition chamber 1001 and the pipes arranged from the discharge valves 1041 to 1046 to the deposition chamber 1001 were prevented by closing the discharge valves 1041 to 1046, by opening the auxiliary valve 1008 and by fully opening the conductance valve 1007 so as to temporarily exhaust the inside portion of the system in a high vacuum state if necessary.

Then, Al was vacuum-evaporated on the n-type layer to have a thickness of 2 µm so as to serve as a backside electrode, so that the photovoltaic device was manufactured (device No. Example-1).

The aforementioned conditions for manufacturing the photovoltaic device are shown in Tables 1-1 and 1-2.

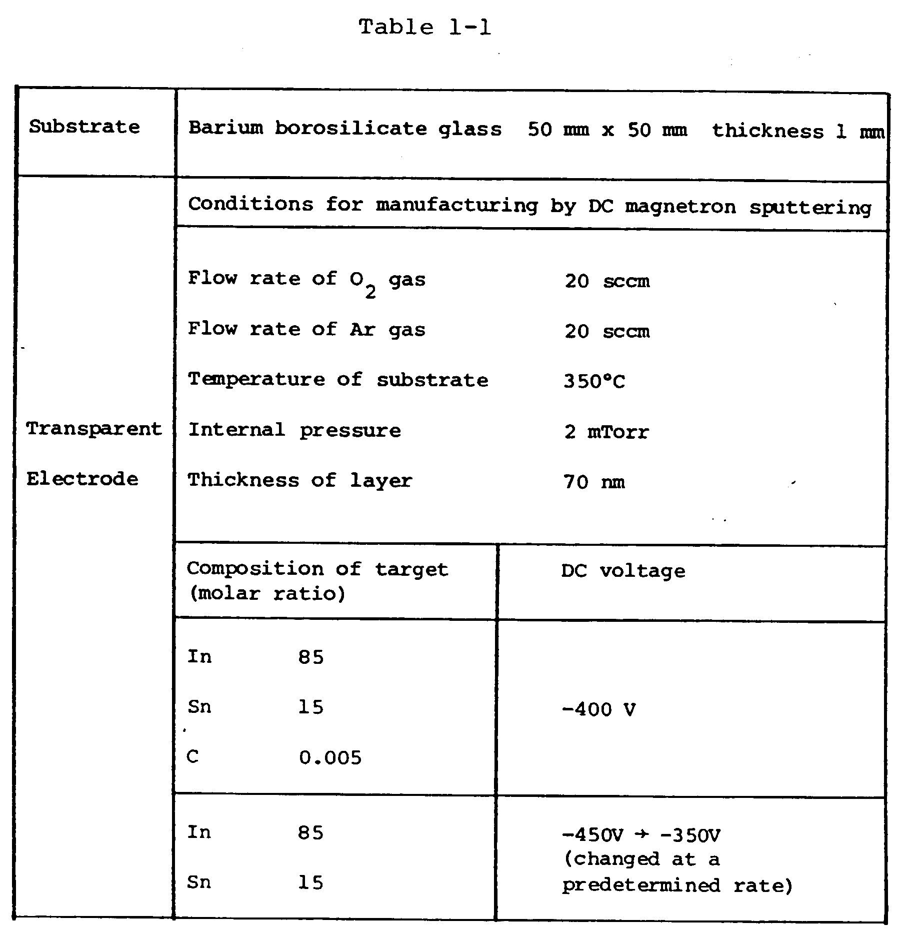

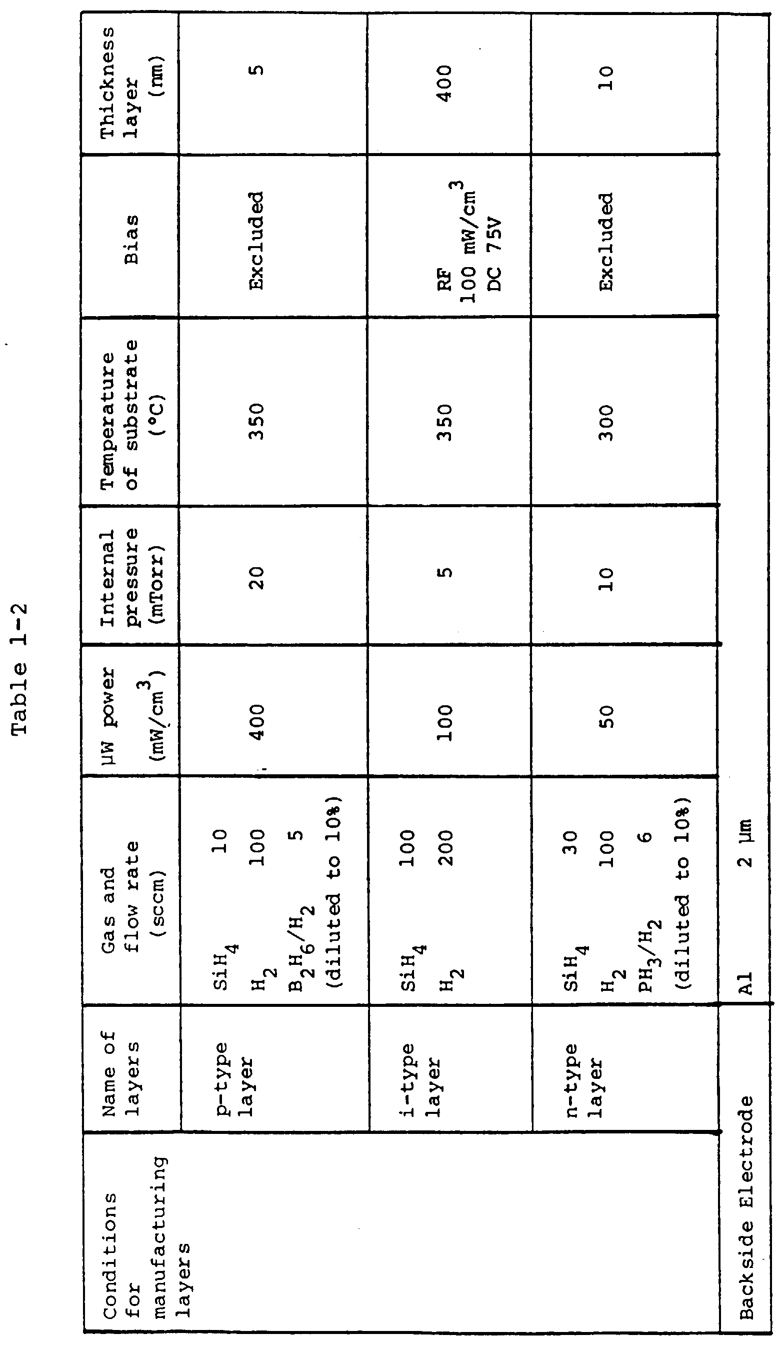

### Comparative Example 1

A conventional photovoltaic device was manufactured by a method similar to that according to Example 1.

First, a transparent electrode was formed on a substrate by the manufacturing apparatus 300 as shown in Fig. 3 and adapted to the DC magnetron sputtering method.

Similarly to Example 1, the substrate was heated to 350°C, and the O₂ gas and the argon was each introduced into the deposition chamber 301 to 20 sccm. Then, the internal pressure of the deposition chamber 301 was made to be 2 mTorr. Then, the voltage of the DC power source 310 was set to -400V and the DC power was supplied to the target 308 so that DC glow discharge was generated. Then, the shutter 311 was opened so that the process of manufacturing the transparent electrode on the substrate 302 was commenced. Then a transparent electrode having a thickness of 70 nm was manufactured, the shutter 311 was closed and the DC power source 301 was turned off so as to stop the DC glow discharge. Then, the gas introduction valve 315 was closed so as to stop the introduction of the Ar gas into the deposition chamber 301, and the opening of the conductance valve 313 was adjusted so as to make the internal pressure of the deposition chamber 301 to be 1 Torr. Then, the transparent electrode was subjected to a heat treatment for one hour, and thus the transparent electrode was manufactured.

Then, the p-, i-, n-type layers and the backside electrode were formed on the transparent electrode under the same conditions as those according to Example 1, so that the photovoltaic device was manufactured (device No. Comparative Example 1).

The initial characteristics and the durabilities of the photovoltaic devices according to Example 1 (device No. Example 1) and Comparative Example 1 (device No. Comparative Example 1) were measured.

The initial characteristics were measured in such a manner that short-circuit currents and series resistances were measured which were obtained by measuring the V-I characteristics while irradiating the photovoltaic devices according to Example 1 (device No. Example 1) and Comparative Example 1 (device No. Comparative Example 1) with light AM-1.5 (100 mW/cm²). As a result, the photovoltaic device according to Example 1 (device No. Example 1) exhibited an excellent short-circuit current of 1.04 times that of the photovoltaic device according to Comparative Example 1 (device No. Comparative Example 1) and an excellent series resistance of 1.37 times the same.

The durability was measured in such a manner that the changes in the photoelectric conversion efficiencies were evaluated after performing the following process: the photovoltaic devices according to Example 1 (device No. Example 1) and Comparative Example 1 (device No. Comparative Example 1) were allowed to stand in a dark place the humidity of which was 85 % so as to be subjected to 30 times of heat cycles each consisting of allowing to stand at a temperature of 85°C for four hours and that at a temperature of -40°C for 30 minutes. As a result, the photovoltaic device according to Example 1 (device No. Example 1) exhibited an excellent photoelectric conversion efficiency of 1.09 times that of the photovoltaic device according to Comparative Example 1 (device No. Comparative Example 1).

Furthermore, the distribution of the carbon atoms in the transparent electrode according to Example 1 (device No. Example 1) was analyzed by using a second ion mass analyzer ("IMS-3F" manufactured by CAMECA), resulting in the quantity of carbon atoms to be considerably reduced from the portion adjacent to the p-type layer toward the substrate.

As a result, a fact was confirmed that the photovoltaic device (device No. Example 1) according to the present invention which used the transparent electrode containing carbons has excellent characteristics in comparison with the conventional photovoltaic device (device No. Comparative Example 1) and therefore the effect of the present invention was confirmed.

### Example 2

The transparent electrode, the p-, i- and n-type layers and the backside electrode were formed under the similar conditions to those for manufacturing the photovoltaic device according to Example 1 except for an arrangement in which alloys shown in Table 2 were used as the material of the target 304 so that the photovoltaic device was manufactured (device No. Examples 2-1 to 2-5).

The initial characteristics and the durability characteristics of the photovoltaic devices (device Nos. Examples 2-1 to 2-5), thus manufactured, were measured by a method similar to that according to Example 1. The results are shown in Table 2.

**Table 2**

| Device No. | Composition of target (mole ratio) | Short-circuit current | Series resistance | Durability characteristics |
|---|---|---|---|---|
| Example 2-1 | In:Sn:C=85:15:0.01 | 1.05 | 1.31 | 1.07 |
| Example 2-2 | In:C=100:0.001 | 1.05 | 1.30 | 1.07 |
| Example 2-3 | Sn:C=100:0.005 | 1.05 | 1.29 | 1.06 |
| Example 2-4 | In:Sn:C=80:20:0.007 | 1.06 | 1.37 | 1.06 |
| Example 2-5 | In:Sn:C=90:10:0.003 | 1.05 | 1.33 | 1.07 |
| * results of measurements were relative values with respect to Comparative Example 1 (device No. Comparative Example 1) | | | | |

Thus, a fact was confirmed that the photovoltaic devices (device Nos. Example 2-1 to 2-5) using the transparent electrode containing carbon atoms according to the present invention have excellent characteristics in comparison with the conventional photovoltaic device (device No. Comparative Example 1) and therefore an effect of the present invention was confirmed.

### Example 3

The transparent electrode, the p-, i- and n-type layers and the backside electrode were formed under the similar conditions to those for manufacturing the photovoltaic device according to Example 1 except for an arrangement in which the n-, i- and p-type layer were formed under conditions shown in Table 3 so that the photovoltaic device was manufactured (device No. Example 3).

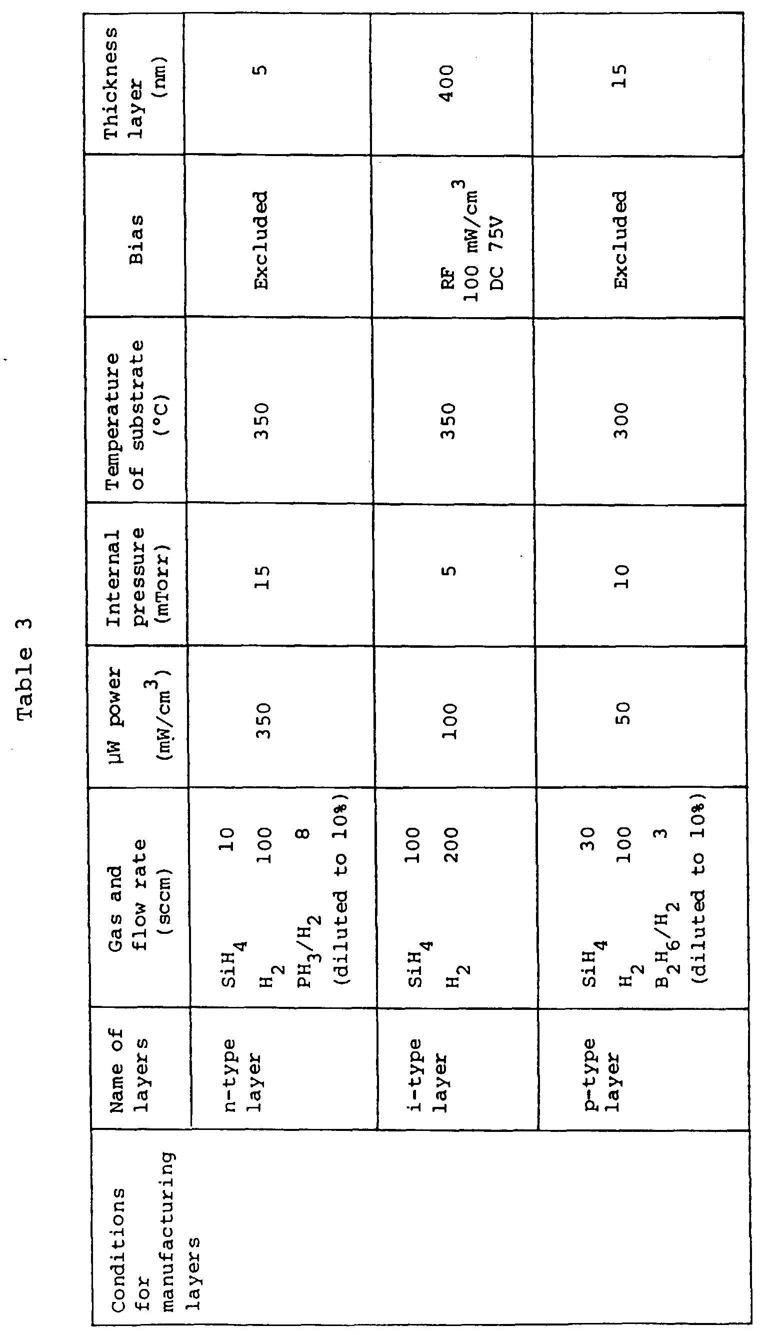

### Comparative Example 2

The transparent electrode, the n-, i- and p-type layers and the backside electrode were formed under the similar conditions to those for manufacturing the photovoltaic device according to Example 1 except for an arrangement in which the transparent electrode was formed on the substrate under the same manufacturing conditions according to Comparative Example 1 so that the photovoltaic device was manufactured (device No. Comparative Example 2).

The initial characteristics and the durability characteristics of the photovoltaic device according to Example 3 (device No. Example 3) and Comparative Example 2 (device No. Comparative Example 2) were measured by a similar method to that according to Example 1. As a result, the photovoltaic device according to Example 3 (device No. Example 3) exhibited a larger short-circuit current of 1.05 times, an excellent series resistance of 1.32 times and an excellent durability characteristics of 1.09 times those of the photovoltaic device according to Comparative Example 2 (device No. Comparative Example 2). Therefore, a fact was confirmed that the photovoltaic device (device No. Example 3) using the transparent electrode containing carbon atoms according to the present invention has excellent characteristics in comparison with those of the conventional photovoltaic device (device No. Comparative Example 2), and therefore an effect of the present invention was confirmed.

### Example 4

The transparent electrode containing carbon atoms was formed on the substrate under the manufacturing conditions according to Example 1, and p-, i-, n-, p-, i-, and n-type layers were formed on the aforementioned transparent electrode by using the CH₄ gas and the GeH₄ gas under the manufacturing conditions shown in Tables 4-1 and 4-2. Then, a ZnO thin film which was 1 µm thick was evaporated on the n-type layer by the DC magnetron sputtering method to serve as a reflection enhancing layer. Furthermore, a silver thin film which was 300 nm thick was evaporated as the DC magnetron sputtering method to serve as a light reflective layer, and then the backside electrode was formed on the silver thin film so that a photovoltaic device was manufactured (device No. Example 4).

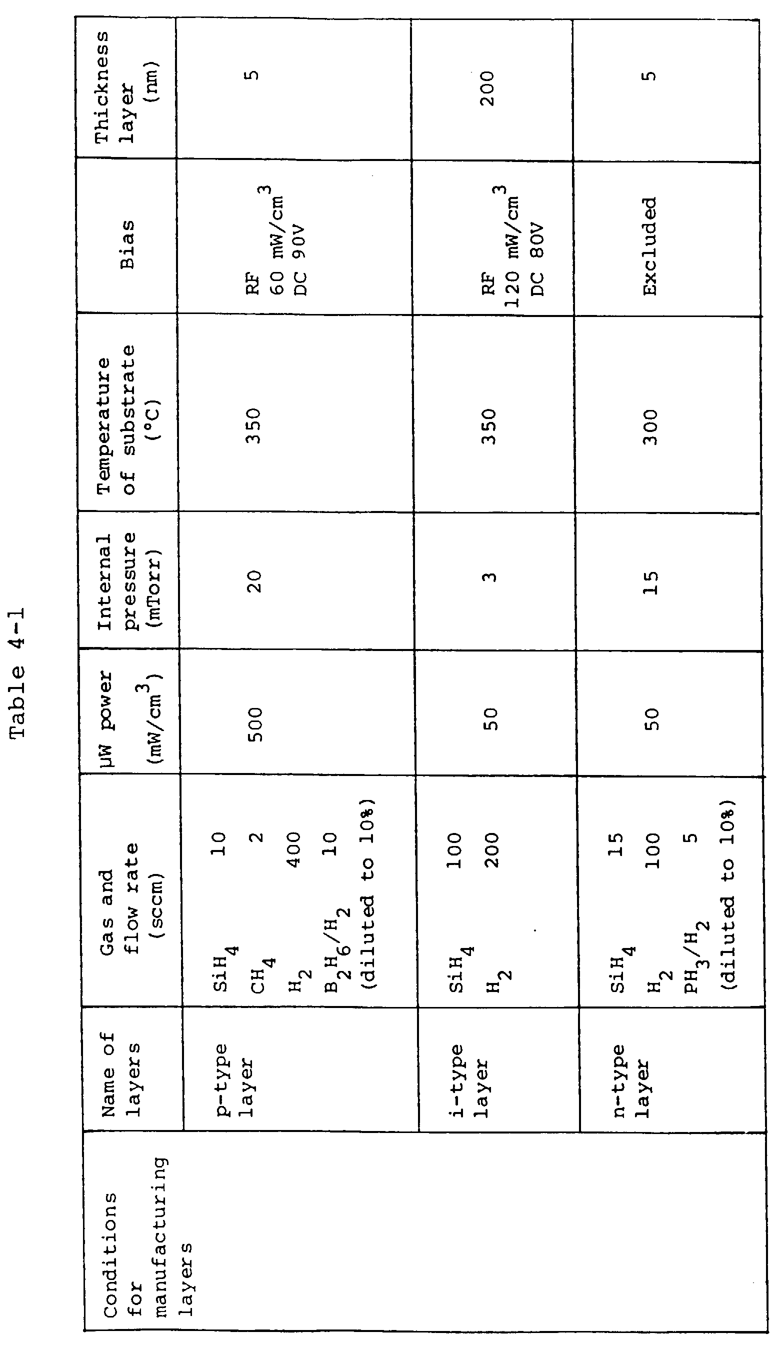

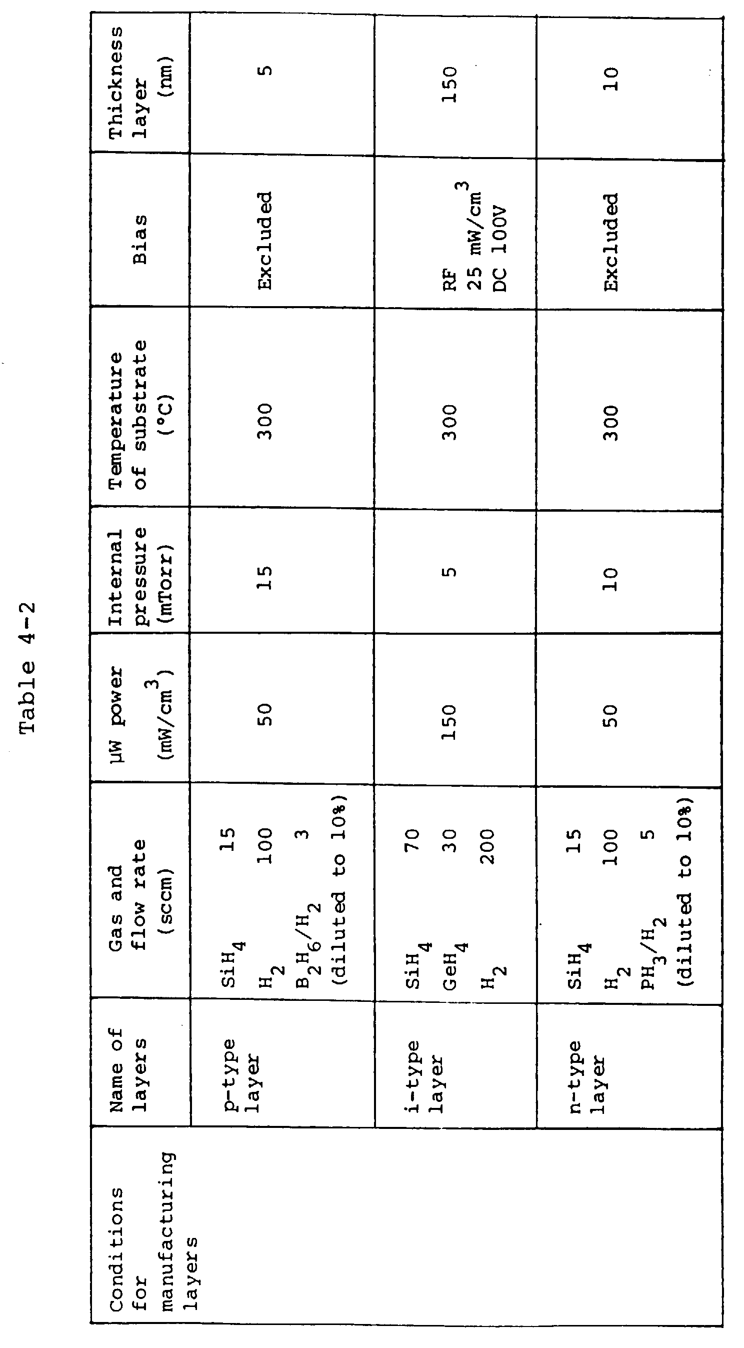

### Comparative Example 3

The transparent electrode, the p-, i-, n-, p-, i-, and n-type layers, a reflection enhancing layer, a light reflective layer, and a backside electrode were formed on the substrate under the same manufacturing conditions as those according to Example 4 except for an arrangement in which the transparent electrode was formed on the substrate under the same conditions as those according to Comparative Example 1, so that a photovoltaic device was manufactured (device No. Comparative Example 3).

The initial characteristics and the durability characteristics of the photovoltaic device (device No. Example 4) according to Example 4 and those according to Comparative Example 3 (device No. Comparative Example 3) were measured by methods each similar to those according to Example 1. As a result, the photovoltaic device according to Example 4 (device No. Example 4) exhibited a larger short-circuit current of 1.07 times, an excellent series resistance of 1.40 times and an excellent durability characteristics of 1.09 times those of the photovoltaic device according to Comparative Example 3 (device No. Comparative Example 3). Therefore, a fact was confirmed that the photovoltaic device (device No. Example 4) using the transparent electrode containing carbon atoms according to the present invention has excellent characteristics in comparison with those of the conventional photovoltaic device (device No. Comparative Example 3), and therefore an effect of the present invention was confirmed.

### Example 5

The photovoltaic device according to the present invention was manufactured by the vacuum evaporation method and the glow discharge decomposition method using microwaves (hereinafter abbreviated to "µW")

First, a transparent electrode, which contained carbon atoms, was formed on a substrate by the manufacturing apparatus 500 shown in Fig. 5 and adapted to the vacuum evaporation method. Referring to Fig. 5, reference numeral 502 represents a 50 mm x 50 mm square substrate which was 1 mm thick and made of barium boron silicate ("7059" manufactured by Coning K.K.).

Referring to Fig. 3, reference numeral 504 represents an evaporation source composed of indium (In) and tin (Sn) contained by a molar ratio of 1:1.

Referring to Fig. 3, reference numeral 510 represents a gas introduction valve which is connected to a CO₂ gas (CO₂/O₂) cylinder (not shown) diluted with an O₂ gas to 50 ppm.

Referring to Fig. 3, reference numeral 512 represents a gas introduction valve connected to an O₂ gas cylinder (not shown).

First, the substrate 502 was heated to 350°C by a heater 503 and the inside a deposition chamber 501 was exhausted by a vacuum pump (not shown) until a vacuum meter 508 indicated a reading of about 1 x 10⁻⁵ Torr. At this time, the gas introduction valves 510 and 512 were gradually opened to introduce the CO₂/O₂ gas and the O₂ gas into the deposition chamber 501. In order to make the flow rate of the CO₂/O₂ gas to be 3 sccm and the O₂ gas to be 7 sccm at this time, corresponding mass-flow controllers 511 and 513 were used to control them. Furthermore, the opening of a (butterfly type) conductance valve 509 was adjusted while observing the vacuum meter 508 so as to make the pressure in the deposition chamber 501 to be 0.3 mTorr. Then, electric power was supplied from an AC power source 506 to a heater 505 so as to heat the evaporation source 504. Then, a shutter 507 was opened so that the process of manufacturing the transparent electrode on the substrate was commenced. Simultaneously, the corresponding mass flow controllers 511 and 513 were used to cause the flow rate of the CO₂/O₂ gas to be changed from 3 sccm to 7 sccm and that of the O₂ gas to be changed from 7 sccm to 3 sccm at a predetermined rate. When a transparent electrode which was 70 nm thick was formed, the shutter 507 was closed and the output from the AC power source 506 was turned off. Furthermore, the gas introduction valves 510 and 512 were closed so as to stop the gas introduction into the deposition chamber 501. Thus, the process of manufacturing the transparent electrode containing carbon atoms was completed.

Then, the p-, i-, n-type layers and the backside electrode were formed on the transparent electrode under the same manufacturing conditions as those according to Example 1, so that a photovoltaic device was manufactured (device No. Example 5).

### Comparative Example 4

A conventional photovoltaic device was manufactured by a method similar to that according to Example 5.

First, a transparent electrode was formed on the substrate by the manufacturing apparatus 500 shown in Fig. 5 and adapted to the vacuum evaporation method.

Similarly to Example 5, the substrate 502 was heated to 350°C by the heater 503, and the gas introduction valve 512 was gradually opened so as to introduce the O₂ gas into the deposition chamber 501 at a flow rate of 7 sccm. Then, the internal pressure of the deposition chamber 501 was adjusted to 0.3 mTorr. Then, electric power was supplied from the AC power source 506 to the heater 505 so as to heat the deposition source 504. Then, the shutter 507 was opened so that the process of manufacturing the transparent electrode on the substarte 502 was commenced. When a transparent electrode which was 70 nm thick was manufactured, the shutter 507 was closed, the output from the AC power source 506 was turned off, and the gas introduction valve 512 was closed so as to stop the introduction of the gas into the deposition chamber 501. Thus, the process of manufacturing the transparent electrode was completed. Furthermore, the p-, i- and n-type layers and the backside electrode were formed on the transparent electrode under the same manufacturing conditions as those according to Example 1, so that the photovoltaic device was manufactured.

The initial characteristics and the durability characteristics of the photovoltaic devices according to Example 5 (device No. Example 5) and Comparative Example 4 (device No. Comparative Example 4) were measured by a similar method to that according to Example 1. As a result, the photovoltaic device according to Example 5 (device No. Example 5) exhibited a larger short-circuit current of 1.05 times, an excellent series resistance of 1.40 times and an excellent durability characteristics of 1.08 times those of the photovoltaic device according to Comparative Example 4 (device No. Comparative Example 4). Therefore, a fact was confirmed that the photovoltaic device (device No. Example 5) using the transparent electrode containing carbon atoms according to the present invention has excellent characteristics in comparison with those of the conventional photovoltaic device (device No. Comparative Example 4), and therefore an effect of the present invention was confirmed.

Furthermore, the distribution of the carbon atoms in the transparent electrode according to Example 5 (device No. Example 5) was analyzed by using a second ion mass analyzer ("IMS-3F" manufactured by CAMECA), resulting in the quantity of carbon atoms to be apparently reduced from the portion adjacent to the p-type layer toward the substrate.

### Example 6

A 50 mm x 50 mm square conductive substrate which was 1 mm thick, made of stainless steel (SUS430BA) and having mirror surfaces was used. A silver thin film serving as a light reflective layer and having a thickness of 300 nm and a ZnO thin film serving as a reflection enhancing layer and having a thickness of 1 µm were deposited by the DC magnetron sputtering method. Then, the n-, i- and p-type layers were formed on the conductive substrate under the manufacturing conditions shown in Table 5.

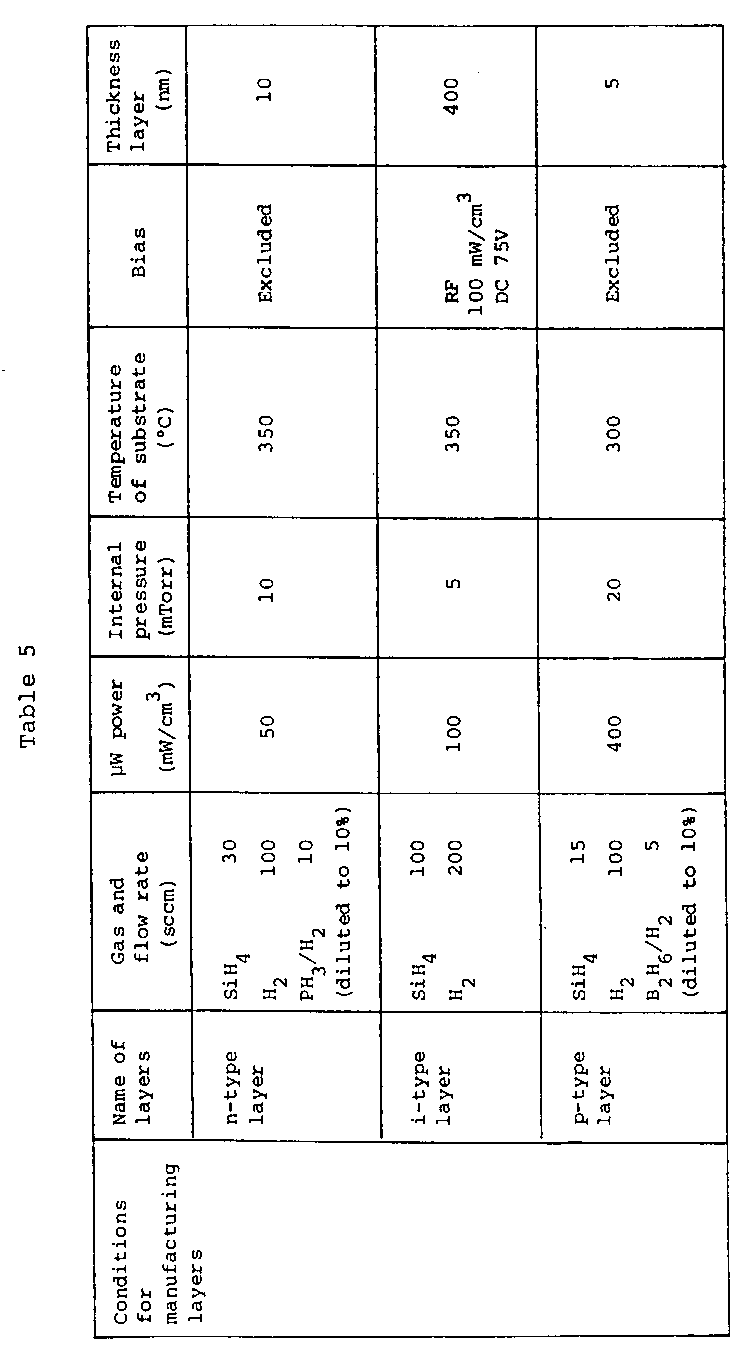

Then, the transparent electrode was formed on the p-type layer by a similar method to that according to Example 5. The temperature of the substrate was made to be 200°C, the flow rate of the CO₂/O₂ gas was made to be 7 sccm, the flow rate of the O₂ gas was made to be 3 sccm and the internal pressure of the deposition chamber 501 was made to be 0.3 mTorr. Then, electric power was supplied from the AC power source 506 to the heater 505 so as to heat the evaporation source 504, and the shutter 507 was opened so that the process of manufacturing the transparent electrode on the substrate 502 was commenced. Simultaneously, the corresponding mass flow controllers 511 and 513 were used to change the flow rate of the CO₂/O₂ gas from 7 sccm to 3 sccm and to change that of the O₂ gas from 3 sccm to 7 sccm at a predetermined rate. When a transparent electrode which was 70 nm thick was manufactured, the shutter 507 was closed, the output from the AC power source 506 was turned off, and the gas introduction valves 510 and 512 were closed so as to stop the introduction of the gases into the deposition chamber 501. Thus, the transparent electrode containing carbon atoms was formed on the p-type layer. Furthermore, Al was evaporated on the transparent electrode to have a thickness of 2 µm and to serve as a collecting electrode by vacuum evaporation, so that the photovoltaic device was manufactured (device No. Example 6).

### Comparative Example 5

A transparent electrode was formed on the p-type layer under the same conditions as those according to Comparative Example 4 except for arrangements in which the light reflective layer, the reflection enhancing layer, the n-, i- and p-type layers were formed on the conductive substrate under the same conditions as those according to Example 6 and the temperature of the substrate was made to be 200°C. Furthermore, a collecting electrode was formed similarly to Example 6, so that a photovoltaic device was manufactured (device No. Comparative Example 5).

The initial characteristics and the durability characteristics of the photovoltaic devices according to Example 6 (device No. Example 6) and Comparative Example 5 (device No. Comparative Example 5) were measured by a similar method to that according to Example 1. As a result, the photovoltaic device according to Example 6 (device No. Example 6) exhibited a larger short-circuit current of 1.06 times, an excellent series resistance of 1.41 times and an excellent durability characteristics of 1.08 times those of the photovoltaic device according to Comparative Example 5 (device No. Comparative Example 5). Therefore, a fact was confirmed that the photovoltaic device (device No. Example 6) using the transparent electrode containing carbon atoms according to the present invention has excellent characteristics in comparison with those of the conventional photovoltaic device (device No. Comparative Example 5), and therefore an effect of the present invention was confirmed.

Furthermore, the distribution of the carbon atoms in the transparent electrode according to Example 6 (device No. Example 6) was analyzed by using a second ion mass analyzer ("IMS-3F" manufactured by CAMECA), resulting in the quantity of carbon atoms to be apparently reduced from the portion adjacent to the p-type layer toward the substarte.

### Example 7

The photovoltaic device according to the present invention was manufactured by the DC magnetron sputtering method and the radio frequency (hereinafter abbreviated to "RF") glow discharge and decomposition method.

First, the transparent electrode containing carbon atoms was formed on the substrate under the same forming conditions as those according to Example 1.

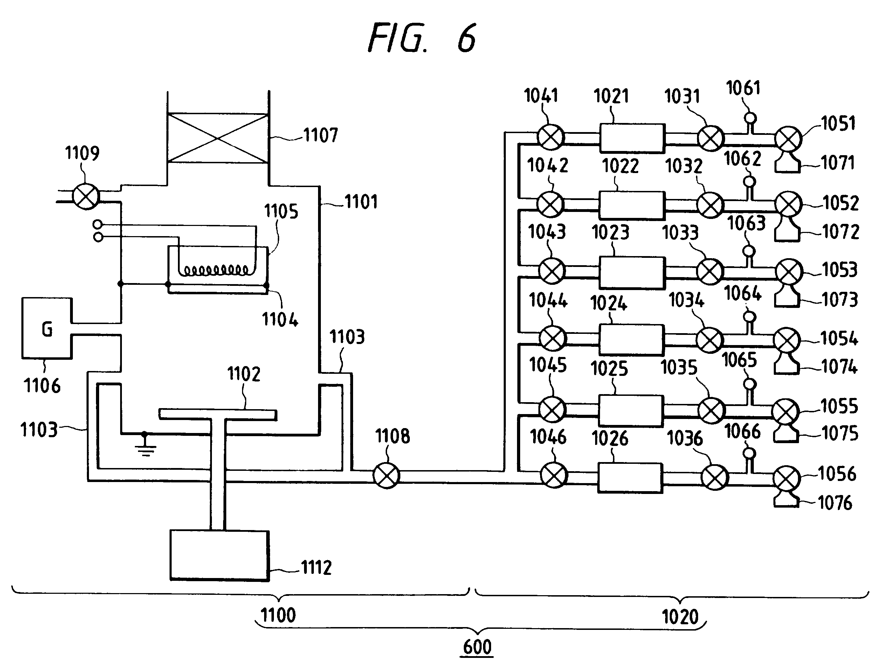

Then, a manufacturing apparatus 600 is, as shown in Fig. 6 and adapted to the RF glow discharge and decomposition method, composed of a raw material gas supply device 1020 and a deposition device 1100 was used to form a non-singlecrystal silicon semiconductor layer on the transparent electrode.

Referring to Fig. 6, reference numeral 1104 represents a substrate on which the aforementioned transparent electrode was formed.

Referring to Fig. 6, the gas cylinders 1071 to 1076 were filled with corresponding raw material gases which were the same as those according to Example 1, and the gases were introduced into the mass flow controllers 1021 to 1026 by the similar manner to that according to Example 1.

After preparation for forming the layers had been completed as described above, the p-, i- and n-type layers were formed on the substrate 1104.

The p-type layer was formed in such a manner that the substrate 1104 was heated to 300°C by the heater 1105, and the discharge valves 1041 to 1043 and the auxiliary valve 1008 were gradually opened so as to introduce the SiH₄ gas, the H₂ gas and the B₂H₄ gas into the deposition chamber 1101 via the introduction pipe 1103. The corresponding mass flow controllers 1021 to 1023 were actuated so as to make the flow rate of the SIH₄ gas to be 2 sccm, that of the H₂ gas to be 50 sccm and that of the B₂H₄/H₂ gas to be 1 sccm. The internal pressure of the deposition chamber 1101 was made to be 1 torr by adjusting the opening of the conductance valve 1107 while observing the vacuum meter 1106. Then, the electric power of the RF power source (not shown) was set to 200 mW/cm³ and the RF power was supplied to a cathode 1102 via an RF matching box 1112 so that RF glow discharge was generated and the process of manufacturing the p-type layer on the transparent electrode was commenced. When the p-type layer which was 5 nm thick was formed, the RF glow discharge was stopped, and the discharge valves 1041 to 1043 and the auxiliary valve 1108 was closed so as to stop the gas introduction into the deposition chamber 1101. Thus, the process of forming the p-type layer was completed.

Then, the i-type layer was formed in such a manner that the substrate 1104 was heated to 300°C by the heater 1105. Then, the discharge valves 1041 and 1042 and the auxiliary valve 1108 were gradually opened so as to introduce the SiH₄ gas and the H₂ gas into the deposition chamber 1101 via the gas introduction pipe 1103. In order to make the flow rate of the SiH₄ gas to be 2 sccm and that of the H₂ gas to be 20 sccm at this time, the corresponding mass flow controllers 1021 and 1022 was used to adjust them. The internal pressure of the deposition chamber 1101 was made to be 1 torr by adjusting the opening of the conductance valve 1107 while observing the vacuum meter 1106. Then, the electric power of the RF power source (not shown) was set to 5 mW/cm² and the RF power was supplied to the cathode 1102 via the RF matching box 1112 so as to generate the RF glow discharge and to commence the process of forming the i-type layer on the p-type layer. When the i-type layer which was 400 nm thick was formed, the RF glow discharge was stopped and the process of forming the i-type layer was completed.

The n-type layer was formed in such a manner that the substrate 1104 was heated to 250°C by the heater 1105 and the discharge valve 1044 was gradually opened so as to introduce the SiH₄ gas, the H₂ gas and the B₂H₆/H₂ gas into the deposition chamber 1101 via the gas introduction pipe 1103. In order to make the gas flow rate of the SiH₄ gas to be 2 sccm, that of the H₂ gas to be 20 sccm and that of the B₂H₆/H₂ gas to be 1 sccm at this time, the corresponding mass flow controllers 1021, 1022 and 1024 were adjusted. The internal pressure of the deposition chamber 1101 was made to be 1 torr by adjusting the opening of the conductance valve 1107 while observing the vacuum meter 1106. Then, the electric power of the RF power source (not shown) was set to 5 mW/cm² and the RF power was supplied to the cathode 1102 via the RF matching box 1112 so as to generate the RF glow discharge. Thus, the process of forming the n-type layer on the i-type layer was commenced. When the n-type layer which was 10 nm thick was formed, the RF glow discharge was stopped and the discharge valves 1041, 1042 and 1044 and the auxiliary valve 1108 were closed so as to stop the gas introduction into the deposition chamber 1101. Thus, the process of forming the n-type layer was completed.

When each of the aforementioned layers was formed, the discharge valves 1041 to 1046 must, of course, be closed completely except for the valves for the required gases. Furthermore, the undesirable retentions of the gases in the deposition chamber 1101 and the pipes arranged from the discharge valves 1041 to 1046 to the deposition chamber 1101 were prevented by closing the discharge valves 1041 to 1046, by opening the auxiliary valve 1108 and by fully opening the conductance valve 1107 so as to temporarily exhaust the inside portion of the system in a high vacuum state if necessary.

Then, the backside electrode was formed on the n-type layer by evaporation similarly to Example 1 so that the photovoltaic device was manufactured (device No. Example 7).

The conditions for manufacturing the photovoltaic device are shown in Tables 6-1 and 6-2.

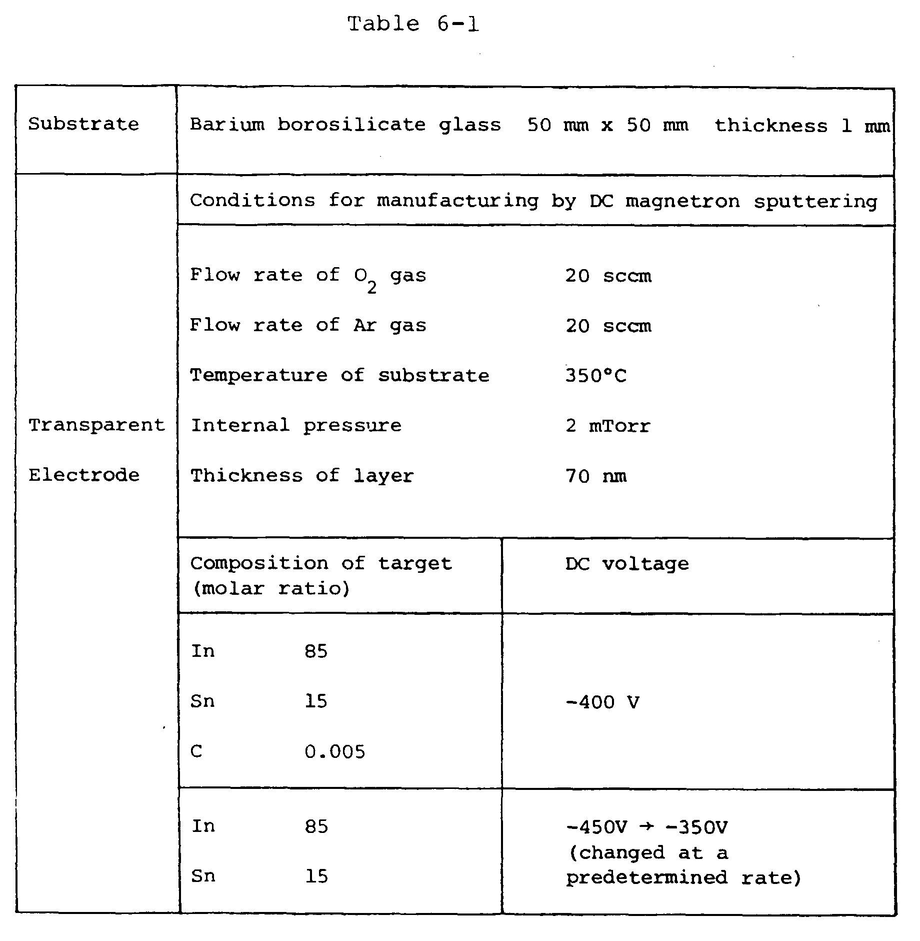

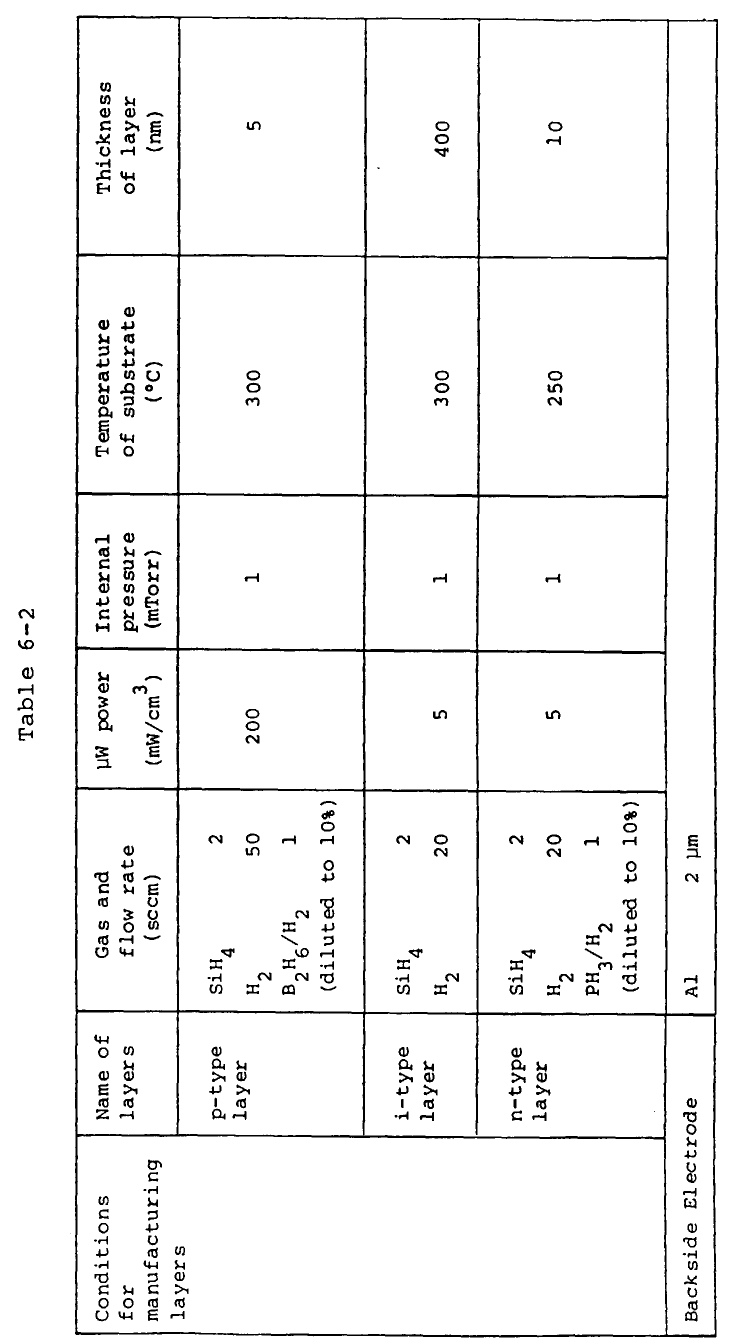

### Comparative Example 6

The p-, i- and n-type layers and the backside electrode were formed on the transparent electrode under the same conditions as those according to Example 7 except for the arrangement in which the transparent electrode which was the same as that according to Comparative Example 1 was used, so that the photovoltaic device was manufactured (device No. Comparative Example 6).

The initial characteristics and the durability characteristics of the photovoltaic devices according to Example 7 (device No. Example 7) and Comparative Example 6 (device No. Comparative Example 6) were measured by a similar method to that according to Example 1. As a result, the photovoltaic device according to Example 7 (device No. Example 7) exhibited a larger short-circuit current of 1.06 times, an excellent series resistance of 1.39 times and an excellent durability characteristics of 1.09 times those of the photovolatic device according to Comparative Example 6 (device No. Comparative Example 6). Therefore, a fact was confirmed that the photovoltaic device (device No. Example 7) using the transparent electrode containing carbon atoms according to the present invention has excellent characteristics in comparison with those of the conventional photovoltaic device (device No. Comparative Example 6), and therefore an effect of the present invention was confirmed.

### Example 8

The photovoltaic device according to the present invention was manufactured by the DC magnetron sputtering method and the microwave (hereinafter abbreviated to "µW") glow discharge and decomposition method.

First, the transparent electrode containing nitrogen atoms was formed on the substrate by the manufacturing apparatus 300 shown in Fig. 3 and adapted to the DC magnetron sputtering method.

Referring to Fig. 3, reference numeral 302 represents a substrate in the form of a 50 mm x 50 mm square, was 1 mm thick and made of barium boron similar glass ("7059" manufactured by coning K.K.).

Referring to Fig. 3, reference numeral 304 represents a target made of indium (In) and tin (Sn) contained by a molar ratio of 85:15, the target 304 being insulated from the deposition chamber 304 by the insulating supporting member 305.

Referring to Fig. 3, reference numerals 314 to 316 represent gas introduction valves which were respectively connected to an oxygen (O₂) gas cylinder, an argon (Ar) gas cylinder, and a cylinder for a nitrogen (N₂) gas (hereinafter abbreviated to "N₂/O₂") diluted with an oxygen (O₂) gas to 50 ppm.

First, the substrate 302 was heated to 350°C by the heater 303, and the inside the deposition chamber 301 was exhausted by a vacuum pump (not shown). When the reading of the vacuum meter 312 has become about 1 x 10⁻⁵ Torr, the gas introduction valves 314 to 316 were gradually opened so as to introduce the O₂ gas, the Ar gas and the N₂/O₂ gas into the deposition chamber 301. In order to make the flow rate of the O₂ gas to be 15 sccm, that of the Ar gas to be 20 sccm and that of the N₂/O₂ gas to be 5 sccm at this time, the corresponding mass flow controllers 317 to 319 were operated. In order to make the internal pressure of the deposition chamber 301 to be 2 mTorr, the opening of the (butterfly type) conductance valve 313 was adjusted while observing the vacuum meter 312. Then, the voltage of the DC power source 306 was set to -400V and the DC power was supplied to the target 304 so as to generate the DC glow discharge. Then, the shutter 307 was opened so that the process for forming the transparent electrode on the substrate 302 was commenced. Simultaneously, in order to cause the flow rate of the O₂ gas to be gradually changed from 15 sccm to 5 sccm at a predetermined rate, and to cause the flow rate of the N₂/O₂ gas to be also gradually changed from 5 sccm to 15 sccm at a predetermined rate, the corresponding mass flow controllers 517 and 519 were operated. When the transparent electrode having a thickness of 70 nm was formed, the shutter 307 was closed, and the output from the DC power source 306 was turned off so that the DC glow discharge was stopped. Then, the gas introduction valves 315 and 316 were closed so as to stop the introductions of the Ar gas and the N₂/O₂ gas into the deposition chamber 301. Furthermore, the internal pressure of the deposition chamber 301 was made to be 1 Torr by adjusting the opening of the conductance valve 313. Then, the transparent electrode was subjected to a heat treatment for one hour so that the process of manufacturing the transparent electrode containing nitrogen atoms was completed. Then, the semiconductor layer was manufactured by a similar method to that according to Example 1.

Then, Al was formed on the n-type layer to serve as the backside electrode by vacuum evaporation to have a thickness of 2 µm, so that the photovoltaic device was manufactured (device No. Example 8).

The above mentioned conditions for manufacturing the photovoltaic device are shown in Tables 7-1 and 7-2.

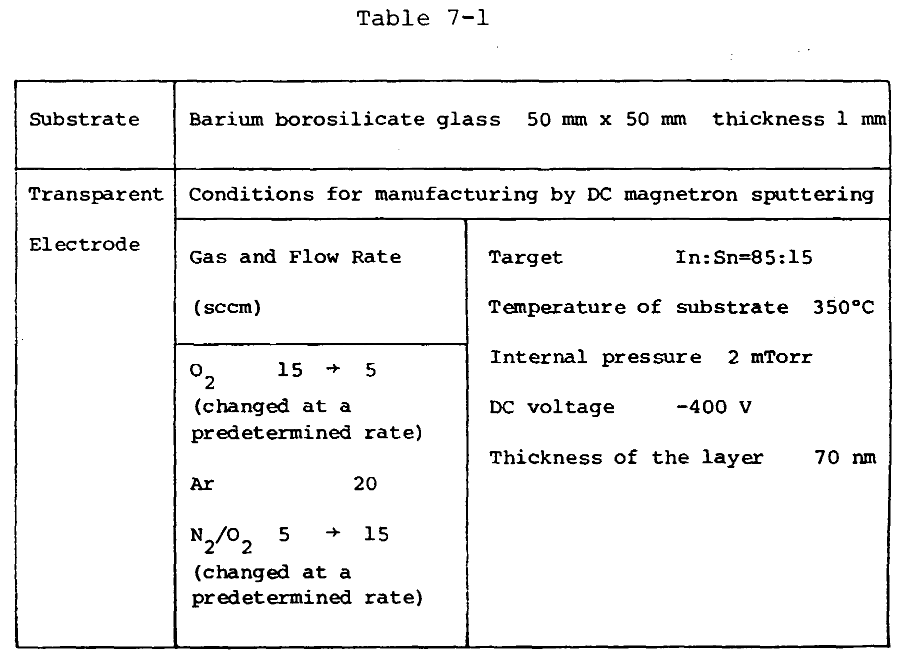

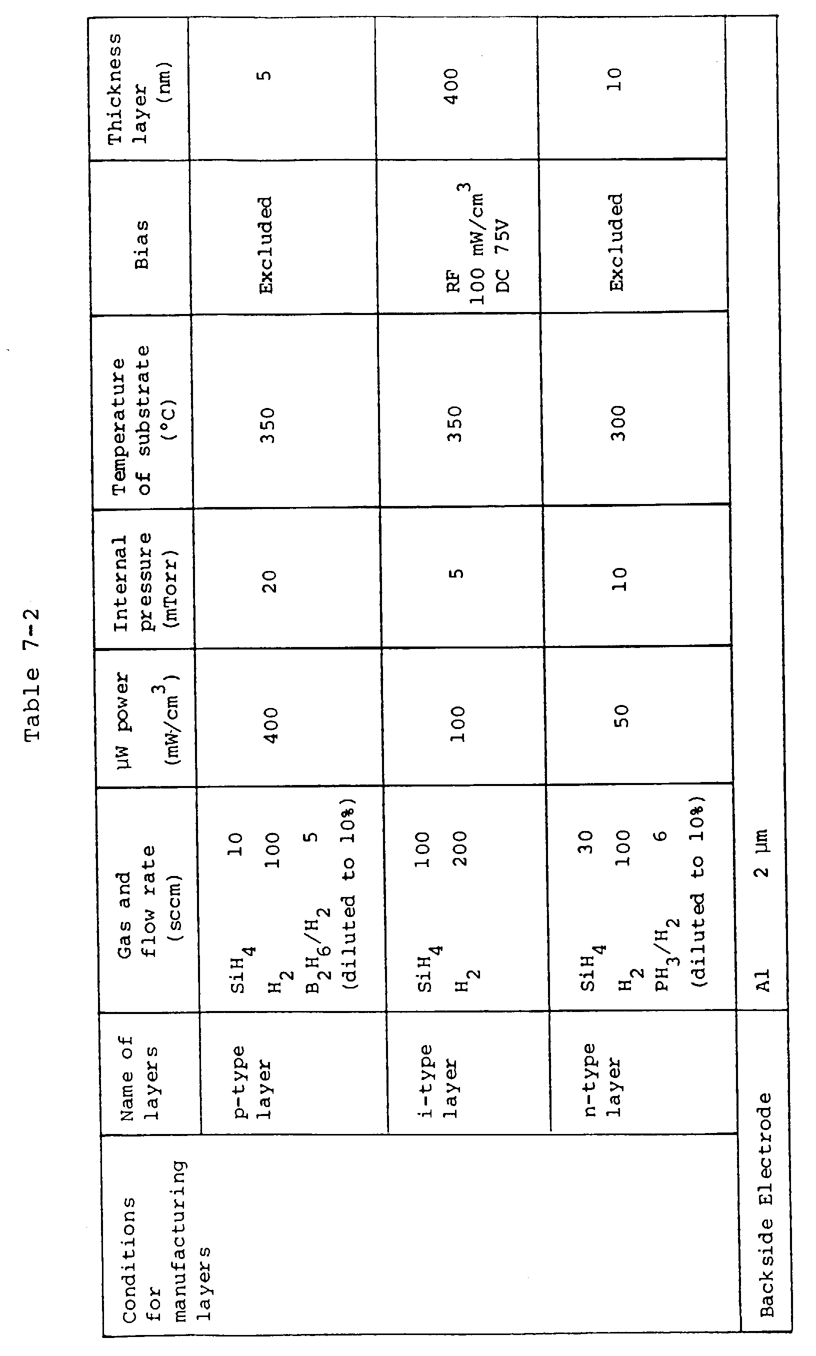

### Comparative Example 7

A conventional photovolatic device was manufactured by a similar method to that according to Example 8.

First, the transparent electrode was formed on the substrate by the manufacturing apparatus 300 shown in Fig. 3 and adapted to the DC magnetron sputtering method.

Similarly to Example 8, the substrate 302 was heated to 350°C, and the O₂ gas was introduced into the deposition chamber 301 at 20 sccm and the argon gas was introduced to the same at 20 sccm. Then, the internal pressure of the deposition chamber 301 was adjusted to 2 mTorr. Then, the voltage of the DC power source 310 was set to -400V and the DC power was supplied to the target 304 so as to generate the DC glow discharge. Then, the shutter 307 was opened so that the process for manufacturing the transparent electrode on the substrate 302 was commenced. When the transparent electrode which was 70 nm thick was formed, the shutter 307 was closed and the output from the DC power source 306 was turned off so that the DC glow discharge was stopped. Then, the gas introduction valve 315 was closed so as to stop the introduction of the Ar gas into the deposition chamber 301. Furthermore, the opening of the conductance valve 313 was adjusted so as to make the internal pressure of the deposition chamber 301 to be 1 Torr. Then, the transparent electrode was subjected to a heat treatment for one hour, and thus the process for manufacturing the transparent electrode was completed.

Then, the p-, i- and n-type layers and the backside electrode were formed on the transparent electrode under the same conditions as those according to Example 8, so that the photovoltaic device was manufactured (device No. Comparative Example 7).

Then, the initial characteristics and the durability of the photovoltaic devices according to Example 8 (device No. Example 8) and Comparative Example 7 (device No. Comparative Example 7) were measured.

The initial characteristics were measured in such a manner that short-circuit currents and series resistances were measured which were obtained by measuring the V-I characteristics while irradiating the photovoltaic devices according to Example 8 (device No. Example 8) and Comparative Example 7 (device No. Comparative Example 7) with light AM-1.5 (100 mW/cm²). As a result, the photovoltaic device according to Example 8 (device No. Example 8) exhibited an excellent short-circuit current of 1.05 times that of the photovoltaic device according to Comparative Example 7 (device No. Comparative Example 7) and an excellent series resistance of 1.40 times the same.

The durability was measured in such a manner that the changes in the photoelectric conversion efficiencies were evaluated after performing the following process: the photovoltaic devices according to Example 8 (device No. Example 8) and Comparative Example 7 (device No. Comparative Example 7) were allowed to stand in a dark place, the humidity of which was 85 % so as to be subjected to 30 times of heat cycles each consisting of allowing to stand at a temperature of 85°C for four hours and that at a temperature of -40°C for 30 minutes. As a result, the photovoltaic device according to Example 8 (device No. Example 8) exhibited an excellent photoelectric conversion efficiency of 1.10 times that of the photovoltaic device according to Comparative Example 7 (device No. Comparative Example 7).

Furthermore, the distribution of the nitrogen atoms in the transparent electrode of the photovoltaic device according to Example 8 (device No. Example 8) was analyzed by using a second ion mass analyzer ("IMS-3F" manufactured by CAMECA), resulting in the quantity of nitrogen atoms to be apparently reduced from the portion adjacent to the p-type layer toward the substrate.

As a result, a face was confirmed that the photovoltaic device (device No. Example 8) according to the present invention which used the transparent electrode containing nitrogen atoms has excellent characteristics in comparison with the conventional photovoltaic device (device No. Comparative Example 7) and therefore the effect of the present invention was confirmed.

### Exmaple 9

The transparent electrode, the p-, i- and n-type layers and the backside electrode were formed on the substrate under the same conditions as those according to Example 8 except for an arrangement made in such a manner that alloys shown in Table 8 were used as the material of the target 304, so that the photovolatic device was manufactured (device Nos. Examples 9-1 to 9-9).

The initial characteristics and the durability of the manufactured photovoltaic devices (device Nos. Examples 9-1 to 9-9) were measured by similar methods to those according to Example 8. The results are shown in Table 8.

**Table 8**

| Device No. | Composition of target (molar ratio) | Short-circuit current | Series resistance | Durability characteristics |
|---|---|---|---|---|
| Example 9-1 | only In | 1.06 | 1.33 | 1.08 |
| Example 9-2 | only Sn | 1.06 | 1.32 | 1.07 |
| Example 9-3 | In:Sn = 4:1 | 1.07 | 1.39 | 1.08 |
| Example 9-4 | In:Sn = 9:1 | 1.07 | 1.38 | 1.09 |
| Example 9-5 | In:C = 100:0.001 | 1.07 | 1.36 | 1.09 |
| Example 9-6 | Sn:C = 100:0.005 | 1.07 | 1.37 | 1.08 |
| Example 9-7 | In:Sn:C=80:20:0.007 | 1.08 | 1.40 | 1.09 |
| Example 9-8 | In:Sn:C=85:15:0.01 | 1.08 | 1.42 | 1.09 |
| Example 9-9 | In:Sn:C=90:10:0.003 | 1.07 | 1.41 | 1.10 |
| * results of measurements were relative values with respect to Comparative Example 7 (device No. Comparative Example 7) | | | | |

As can be understood from Table 8, a fact was confirmed that the photovoltaic devices (device Nos. Examples 9-1 to 9-9, containing nitrogen atoms according to the present invention have excellent characteristics in comparison with the conventional photovoltaic devices (device No. Comparative Example 7) and therefore an effect of the present invention was confirmed.

### Example 10

The transparent electrode, the n-, i- and p-type layers and the backside electrode were formed on the substrate under the same conditions as those according to Example 8 except for an arrangement in which the n-, i- and p-type layers were formed under conditions shown in Table 9, so that the photovoltaic device was manufactured (device No. Example 10).

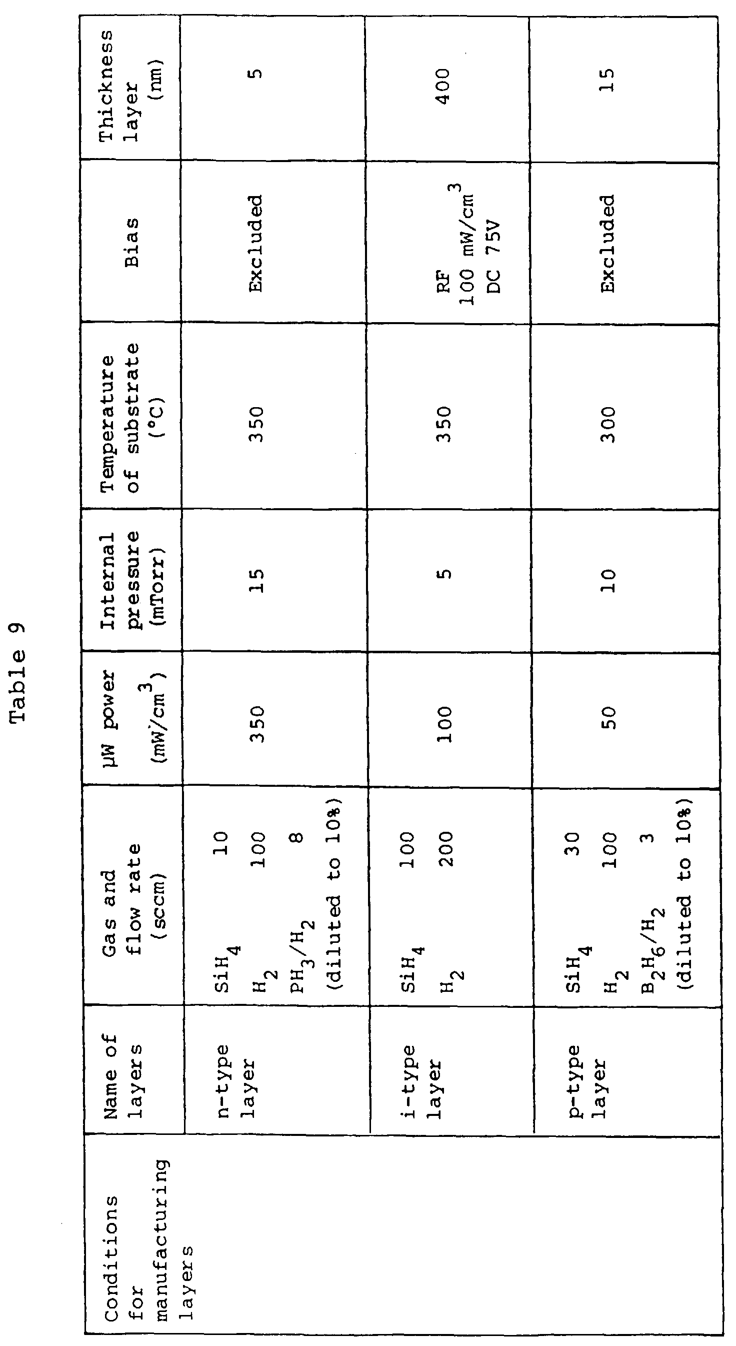

### Comparative Example 8

The transparent electrode, the n-, i- and p-type layers and the backside electrode were formed on the substrate under the same conditions as those according to Example 10 except for an arrangement in which the transparent electrode was formed on the substrate under the same conditions as those according to Comparative Example 7, so that the photovoltaic device was manufactured (device No. Comparative Example 8).

The initial characteristics and the durability characteristics of the photovoltaic devices according to Example 10 (device No. Example 10) and Comparative Example 8 (device No. Comparative Example 8) were measured by a similar method to that according to Example 8. As a result, the photovolatic device according to Example 10 (device No. Example 10) exhibited a larger short-circuit current of 1.06 times, an excellent series resistance of 1.37 times and an excellent durability characteristics of 1.10 times those of the photovolatic device according to Comparative Example 8 (device No. Comparative Example 8). Therefore, a fact was confirmed that the photovoltaic device (device No. Example 10) using the transparent electrode containing nitrogen atoms according to the present invention has excellent characteristics in comparison with those of the conventional photovoltaic device (device No. Comparative Example 8), and therefore an effect of the present invention was confirmed.

### Example 11

The transparent electrode containing nitrogen atoms was formed on the substrate under the same conditions as those according to Example 8, and the p-, i-, n-, p-, i- and n-type layers were formed on the aforesaid transparent electrode by using the CH₄ gas and the GeH₄ gas under the conditions shown in Tables 10-1 and 10-2. Then, a ZnO thin film was formed by evaporation on the n-type layer to serve as a reflection enhancing layer by the DC magnetron sputtering method to have a thickness of 1 µm. Furthermore, a silver thin film was formed to serve as a light reflective layer by the DC magnetron sputtering method to have a thickness of 300 nm, and the backside electrode was formed on the silver thin film similar to Example 10, so that the photovoltaic device was manufactured (device No. Example 11).

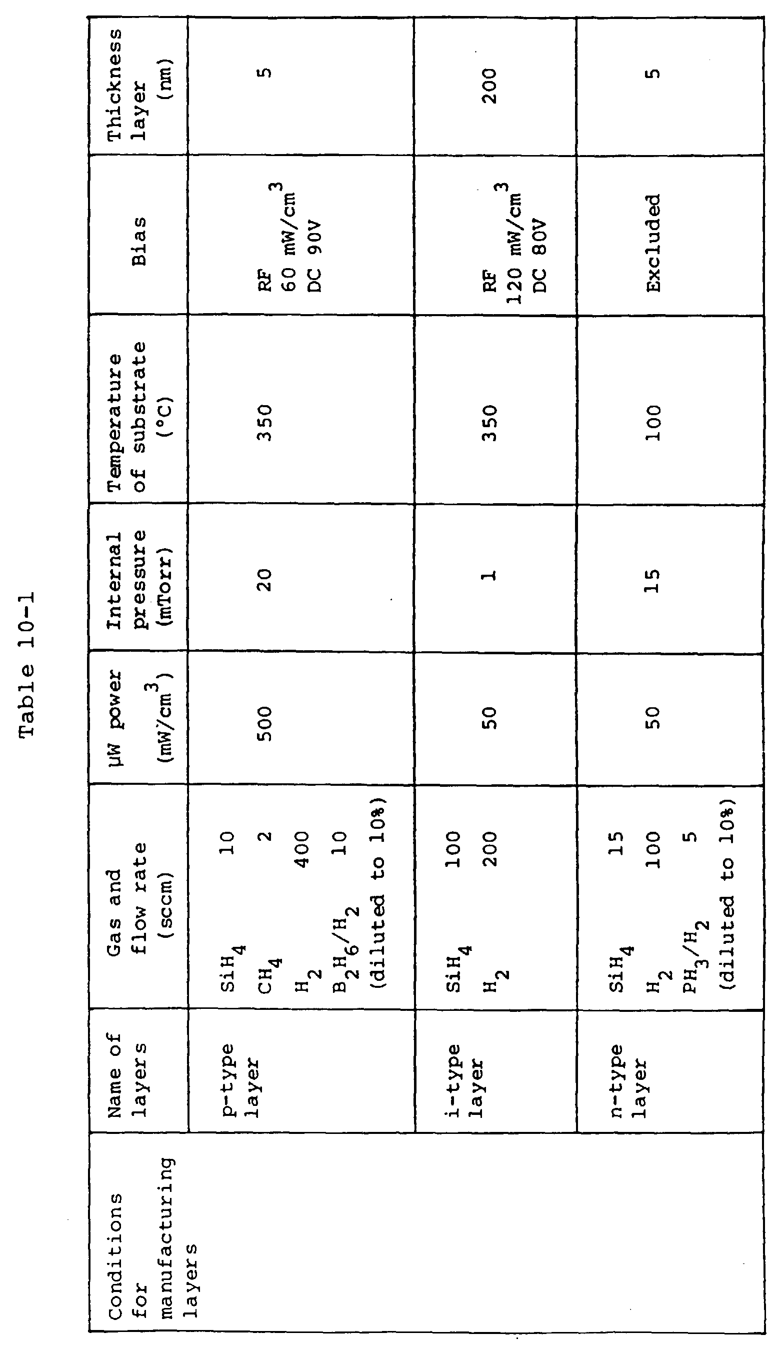

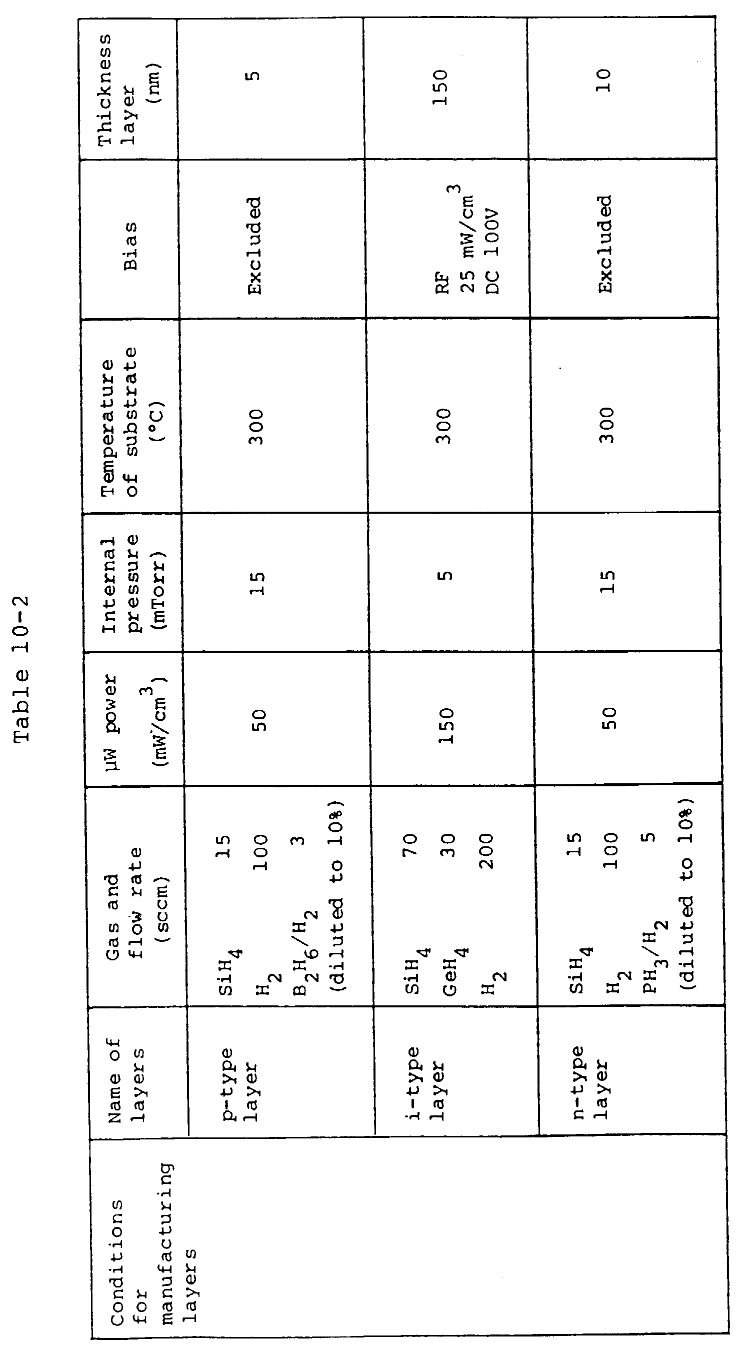

### Comparative Example 9

The transparent electrode, the p-, i-, n-, p-, i- and n-type layers, the reflection enhancing layer, the light reflective layer, and a backside electrode were formed on the substrate under the same conditions as those according to Example 11 except for an arrangement made in such a manner that the transparent electrode was formed on the substrate under the same condition as those according to Comparative Example 7, so that the photovolatic device was manufactured (device No. Comparative Example 9).

The initial characteristics and the durability characteristics of the photovoltaic devices according to Example 11 (device No. Example 11) and Comparative Example 9 (device No. Comparative Example 9) were measured by a similar method to that according to Example 8. As a result, the photovoltaic device according to Example 11 (device No. Example 11) exhibited a larger short-circuit current of 1.08 times, an excellent series resistance of 1.41 times and an excellent durability characteristics of 1.10 times those of the photovoltaic device according to Comparative Example 9 (device No. Comparative Example 9). Therefore, a fact was confirmed that the photovoltaic device (device No. Example 11) using the transparent electrode containing nitrogen atoms according to the present invention has an excellent characteristics in comparison with those of the conventional photovoltaic device (device No. Comparative Example 9), and therefore an effect of the present invention was confirmed.

### Example 12

The photovoltaic device according to the present invention was manufactured by the vacuum evaporation method and the microwave (hereinafter abbreviated to "µW") and the glow discharge and decomposition method.

First, the transparent electrode containing nitrogen atoms was formed on the substrate by the manufacturing apparatus 500 shown in Fig. 5 and adapted to the vacuum evaporation method.

Referring to Fig. 5, reference numeral 502 represents a substrate in the form of a 50 mm x 50 mm square which was 1 mm thick and which was made of barium boron silicate glass ("7059" manufactured by Corning).

Referring to Fig. 5, reference numeral 504 represents an evaporation source composed of indium (In) and tin (Sn) contained at a molar ratio of 1 : 1.

Referring to Fig. 5, reference numeral 510 represents a gas introduction valve which was connected to a cylinder (not shown) for (N₂/O₂) gas obtained by diluting an N₂ gas with an O₂ gas to 50 ppm.

Referring to Fig. 5, reference numeral 512 represents a gas introduction valve which was connected to an O₂ gas cylinder (not shown).

First, the substrate 502 was heated to 350°C by the heater 503, and the inside of the deposition chamber 501 was exhausted by a vacuum pump (not shown). When the reading of the vacuum meter 508 had become about 1 x 10⁻⁵ Torr, the gas introduction valves 510 and 512 were gradually opened so as to introduce the N₂/O₂ gas and the O₂ gas into the deposition chamber 501. In order to make the introduction flow rate of the N₂/O₂ gas to be 3 sccm and that of the O₂ gas to be 7 sccm at this time, the corresponding mass flow controllers 511 and 513 were operated. Furthermore, the internal pressure of the deposition chamber 501 was made to be 0.3 mTorr by adjusting the opening of the (butterfly type) conductance valve 509 while observing the vacuum meter 508. Then, electric power was supplied from the AC power source 506 to the heater 505 so as to heat the evaporation source 504. Then, the shutter 507 was opened so as to commence the process for manufacturing the transparent electrode on the substrate 502. Simultaneously, the introduction of the N₂/O₂ gas was changed from 3 sccm to 7 sccm at a predetermined rate and that of the O₂ gas was changed from 7 sccm to 3 sccm at a predetermined rate by operating the corresponding mass flow controllers 511 and 513. When a transparent electrode which was 70 nm thick was formed, the shutter 507 was closed, the output from the AC power source 506 was turned off and the gas introduction valves 510 and 512 were closed, so the gas introduction into the deposition chamber 501 was stopped. Thus, the transparent electrode containing nitrogen atoms was manufactured.

Then, the p-, i- and n-type layers and the backside electrode were formed on the transparent electrode under the same conditions as those according to Example 8, so that the photovoltaic device was manufactured (device No. Example 12).

### Comparative Example 10

A, conventional photovoltaic device was manufactured by a method similar to that according to Example 12.

First, the transparent electrode was formed on the substrate by the manufacturing apparatus 500 shown in Fig. 5 and adapted to the vacuum evaporation method.

Similarly to Example 5, the substrate 502 was heated to 350°C by the heater 503, and the gas introduction valve 512 was gradually opened so as to introduce the O₂ gas into the deposition chamber 501 at 10 sccm. Furthermore, the internal pressure of the deposition chamber 501 was made to be 0.3 mTorr. Then, electric power was supplied from the AC power source 506 to the heater 505 so as to heat the evaporation source 504. Then, the shutter 507 was opened so that the process for manufacturing the transparent electrode on the substrate 502 was commenced. When the transparent electrode which was 70 nm thick was formed, the shutter 507 was closed and the output from the AC power source 506 was turned off. Furthermore, the gas introduction valve 512 was closed so as to stop the gas introduction into the deposition chamber 501. Thus, the process for manufacturing the transparent electrode was completed. Furthermore, the p-, i- and n-type layers and the backside electrode were formed on the transparent electrode under the same conditions as those according to Example 1, so that the photovoltaic device was manufactured (device No. Comparative Example 10).

The initial characteristics and the durability characteristics of the photovoltaic devices according to Example 12 (device No. Example 12) and Comparative Example 10 (device No. Comparative Example 10) were measured by a similar method to that according to Example 8. As a result, the photovoltaic device according to Example 12 (device No. Example 12) exhibited a larger short-circuit current of 1.07 times, an excellent series resistance of 1.42 times and an excellent durability characteristics of 1.10 times those of the photovoltaic device according to Comparative Example 10 (device No. Comparative Example 10). Therefore, a fact was confirmed that the photovolatic device (device No. Example 5) using the transparent electrode containing nitrogen atoms according to the present invention has excellent characteristics in comparison with those of the conventional photovoltaic device (device No. Comparative Example 4), and therefore an effect of the present invention was confirmed.

Furthermore, the distribution of the nitrogen atoms in the transparent electrode of the photovoltaic device according to Example 12 (device No. Example 12) was analyzed by using the second ion mass analyzer ("IMS-3F" manufactured by CAMERA), resulting in the quantity of nitrogen atoms to be apparently reduced from the portion adjacent to the p-type layer toward the substrate.

### Example 13

A 50 mm x 50 mm square conductive substrate which was 1 mm thick, made of stainless steel (SUS430BA) and having mirror surfaces was used. A silver thin film serving as a light reflective layer and having a thickness of 300 nm and a ZnO thin film serving as a reflection enhancing layer and having a thickness of 1 µm were formed by the DC magnetron sputtering method. Then, the n-, i- and p-type layers were formed on the conductive substrate under the manufacturing conditions shown in Table 11.

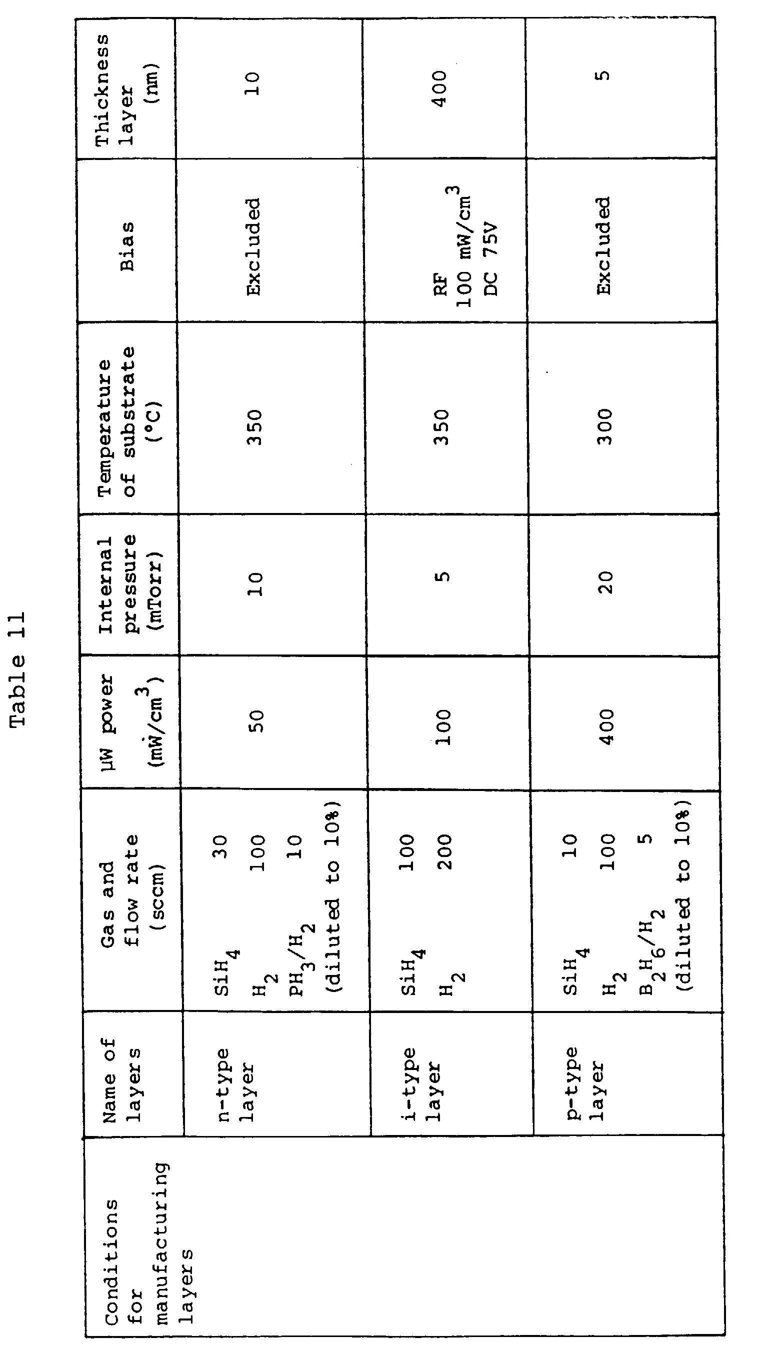

Then, the transparent electrode was formed on the p-type layer by a similar method to that according to Example 12. The temperature of the substrate was made to be 200°C, the flow rate of the N₂/O₂ gas was made to be 7 sccm, the flow rate of the O₂ gas was made to be 3 sccm and the internal pressure of the deposition chamber 501 was made to be 0.3 mTorr. Then, electric power was supplied from the AC power source 506 to the heater 505 so as to heat the evaporation source 504, and the shutter 507 was opened so that the process of manufacturing the transparent electrode on the substrate 502 was commenced. Simultaneously, the corresponding mass flow controllers 511 and 513 were used to change the flow rate of the N₂/O₂ gas from 7 sccm to 3 sccm at a predetermined rate and to change that of the O₂ gas from 3 sccm to 7 sccm at a predetermined rate. When a transparent electrode which was 70 nm thick was manufactured, the shutter 507 was closed, the output from the AC power source 506 was turned off, and the gas introduction valves 510 and 512 were closed so as to stop the introduction of the gases into the deposition chamber 501. Thus, the transparent electrode containing nitrogen atoms was formed on the p-type layer. Furthermore, Al was evaporated on the transparent electrode to have thickness of 2 µm and to serve as a collecting electrode by vacuum evaporation, so that the photovoltaic device was manufactured (device No. Example 13).

### Comparative Example 11

The transparent electrode was formed on the p-type layer under the same conditions as those according to Comparative Example 10 except for arrangements made in such a manner that the light reflective layer, the reflection enhancing layer, the n-, i- and p-type layers were formed on the conductive substrate under the same manufacturing conditions as those according to Example 13 and the temperature of the substrate was made to be 200°C. Furthermore, the collecting electrode was formed similarly to Example 13, so that the photovoltaic device was manufactured (device No. Comparative Example 11).

The initial characteristics and the durability characteristics of the photovoltaic devices according to Example 13 (device No. Example 13) and Comparative Example 11 (device No. Comparative Example 11) were measured by a similar method to that according to Example 8. As a result, the photovoltaic device according to Example 13 (device No. Example 13) exhibited a larger short-circuit current of 1.07 times, an excellent series resistance of 1.44 times and an excellent durability characteristics of 1.11 times those of the photovoltaic device according to Comparative Example 11 (device No. Comparative Example 11). Therefore, a fact was confirmed that the photovoltaic device (device No. Example 13) using the transparent electrode containing nitrogen atoms according to the present invention has excellent characteristics in comparison with those of the conventional photovoltaic device (device No. Comparative Example 11), and therefore an effect of the present invention was confirmed.

Furthermore, the distribution of the nitrogen atoms in the transparent electrode of the photovoltaic device according to Example 13 (device No. Example 13) was analyzed by using a second ion mass analyzer (IMS-3F" manufactured by CAMECA), resulting in the quantity of nitrogen atoms to be considerably reduced from the portion adjacent to the p-type layer toward the substrate.

### Example 14

The photovoltaic device according to the present invention was manufactured by the DC magnetron sputtering method and the radio frequency (hereinafter abbreviated to "RF") glow discharge and decomposition method.

First, the transparent electrode containing nitrogen atoms was formed on the substrate under the same manufacturing conditions as those according to Example 8.

Then, the manufacturing apparatus 600 as shown in Fig. 6 and adapted to the RF glow discharge and decomposition method, composed of the raw material gas supply device 1020 and the deposition device 1100 was used to manufacture the non-single-crystal silicon semiconductor layer on the transparent electrode.

Referring to Fig. 6, reference numeral 1104 represents a substrate on which the aforementioned transparent electrode was formed.

Referring to Fig. 6, the gas cylinders 1071 to 1076 respectively were filled with the raw material gases which are the same as those according to Example 8, and the aforementioned gases were introduced into the mass flow controllers 1021 to 1026 in a similar operation manner to that according to Example 8.

After the preparation for forming the layers had been completed as described above, the p-, i- and n-type layers were formed on the substrate 1104.

The p-type layer was manufactured in such a manner that the substrate 1104 was heated to 300°C by the heater 1105, and the discharge valves 1041 to 1043 and the auxiliary valve 1108 were gradually opened, so that the SiH₄ gas, the H₂ gas and the B₂H₆/H₂ gas were introduced into the deposition chamber 1101 via the gas introduction pipe 1103. In order to make the introduction flow rate of the SiH₄ gas to be 2 sccm, that of the H₂ gas to be 50 sccm and that of the B₂H₆/H₂ gas to be 1 sccm at this time, the corresponding mass flow controllers 1021 to 1023 were operated. The internal pressure of the deposition chamber 1101 was made to be 1 Torr by adjusting the opening of the conductance valve 1107 while observing the vacuum meter 1106. Then, the electric power of the RF power source (not shown) was set to 200 mW/cm³, and the RF power was supplied to the cathode 1102 via the RF matching box 1112 so as to generate the RF glow discharge. Thus, the process of forming the p-type layer on the transparent electrode was commenced. When the p-type layer which was 5 nm thick was formed, the RF glow discharge was stopped and the discharge valves 1041 to 1043 and the auxiliary valve 1108 were closed so as to stop the gas introduction into the deposition chamber 1101. Thus, the process of forming the p-type layer was completed.

Then, the i-type layer was formed in such a manner that the substrate 1104 was heated to 300°C by the heater 1105, and the discharge valves 1041 and 1042 and the auxiliary valve 1108 were gradually opened so as to introduce the SiH₄ gas and the H₂ gas into the deposition chamber 1101 via the gas introduction pipe 1103. In order to make the flow rate of the SiH₄ gas to be 2 sccm and that of the H₂ gas to be 20 sccm at this time, the corresponding mass flow controllers 1021 and 1022 were operated. In order to make the internal pressure of the deposition chamber 1101 to be 1 Torr, the opening of the conductance valve 1107 was adjusted while observing the vacuum meter 1106. Then, the electric power of an RF power source (not shown) was set to 5 mW/cm³, and the RF power was supplied to the cathode 1102 via the RF matching box 1112 so as to generate the RF glow discharge. As a result, the process of forming the i-type layer on the p-type layer was commenced. When the i-type layer which was 400 nm thick was formed, the RF glow discharge was stopped and the process of forming the i-type layer was completed.

Then, the n-type layer was formed in such a manner that the substrate 1104 was heated to 250°C by the heater 1105, and the discharge valve 1044 was gradually opened so as to introduce the SiH₄ gas, the H₂ gas and the B₂H₆/H₂ gas into the deposition chamber 1101 via the gas introduction pipe 1103. In order to make the flow rate of the SiH₄ gas to be 2 sccm, that of the H₂ gas to be 20 sccm and that of the B₂H₆/H₂ gas to be 1 sccm at this time, the corresponding mass flow controllers 1021, 1022 and 1024 were operated. The internal pressure of the deposition chamber 1101 was made to be 1 Torr by adjusting the opening of the conductance valve 1107 while observing the vacuum meter 1106. Then, the electric power of an RF power source (not shown) was set to 5 mW/cm³, and the RF power was supplied to the cathode 1102 via the RF matching box 1112 so as to generate the RF glow discharge. Thus, the process of forming the n-type layer on the i-type layer was commenced. When the n-type layer which was 10 nm thick was formed, the RF glow discharge was stopped and the discharge valves 1041, 1042 and 1044 and the auxiliary valve 1108 was closed so as to stop the gas introduction into the deposition chamber 1101. Thus, the process of manufacturing the n-type layer was completed.

When each of the aforementioned layers was formed, the discharge valves 1041 to 1046 must, of course, be closed completely except for the valves for the required gases. Furthermore, the undesirable retentions of the gases in the deposition chamber 1101 and the pipes arranged from the discharge valves 1041 to 1046 to the deposition chamber 1101 were prevented by closing the discharge valves 1041 to 1046, by opening the auxiliary valve 1108 and by fully opening the conductance valve 1107 so as to temporarily exhaust the inside portion of the system in a high vacuum state if necessary.

Then, the backside electrode was formed on the n-type layer by evaporation similarly to Example 1 so that the photovoltaic device was manufactured (device No. Example 14).

The conditions for manufacturing the photovoltaic device are shown in Tables 12-1 and 12-2.

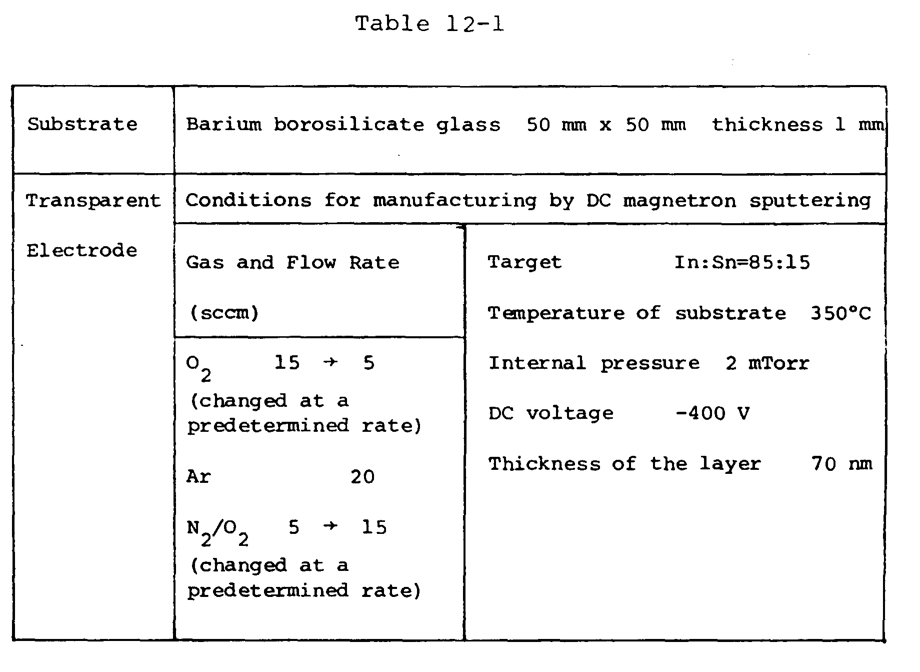

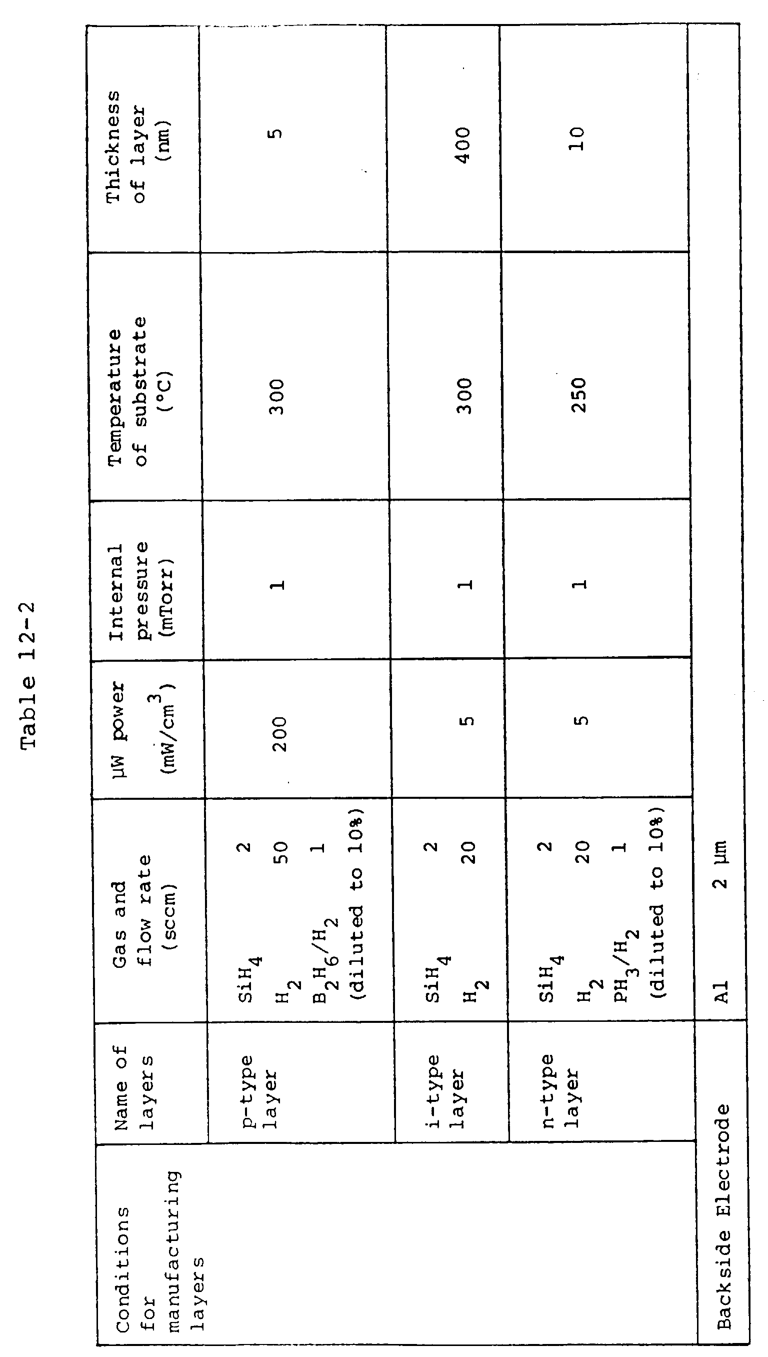

### Comparative Example 12

The p-, i- and n-type layers and the backside electrode were formed on the transparent electrode under the same conditions as those according to Example 14 except for an arrangement made in such a manner that the transparent electrode which was the same as that according to Comparative Example 7 was used, so that the photovoltaic device was manufactured (device No. Comparative Example 12).

The initial characteristics and the durability characteristics of the photovoltaic devices according to Example 14 (device No. Example 14) and Comparative Example 12 (device No. Comparative Example 12) were measured by a similar method to that according to Example 8. As a result, the photovoltaic device according to Example 14 (device No. Example 14) exhibited a larger short-circuit current of 1.07 times, an excellent series resistance of 1.41 times and an excellent durability characteristics of 1.10 times those of the photovoltaic device according to Comparative Example 12 (device No. Comparative Example 12). Therefore, a fact was confirmed that the photovoltaic device (device No. Example 14) using the transparent electrode containing nitrogen atoms according to the present invention has excellent characteristics in comparison with those of the conventional photovoltaic device (device No. Comparative Example 12), and therefore an effect of the present invention was confirmed.

In the transparent electrods according to the aforementioned examples, nitrogen atoms was distributed in an exponential manner in a region of 30 to 500 Å in the direction of the thickness, and the maximum distribution density was 5 to 1000 ppm.

The photovoltaic device, composed of the non-single-crystal silicon semiconductor layer having the transparent electrode containing carbon atoms or nitrogen atoms or both carbon atoms and nitrogen atoms, exhibited effects in that the series resistance relating to the transparent electrode was reduced and the transmissivity was improved. Furthermore, the adhesion between the semiconductor layer and the transparent electrode was improved, causing leak to be prevented even if it is used for a long time. As a result, the durability characteristics of the photovoltaic device were improved.

In addition, since a large quantity of carbon atoms, or nitrogen atoms or both carbon atoms and nitrogen atoms is distributed in the transparent electrode in the portion adjacent to the semiconductor layer, the structural distortion taken place due to the difference in the material between the transparent electrode and the semiconductor layer can be prevented satisfactorily.

Although the present invention has been described with reference to the specific examples, various modifications and variations can be easily made. Accordingly, the foregoing disclosure should be interpreted as illustrative only and not to be interpreted in a limiting sense.

## Claims

1. A photovoltaic device (100) comprising:
a conductive member (101);
a semiconductor layer (104, 105, 106) formed on said conductive member (101), made of a non-single-crystal silicon-based semiconductor material; and
a transparent electrode (107) stacked on said semiconductor layer (104, 105, 106), wherein
said transparent electrode (107) is made of an oxide containing carbon atoms, with the oxide being selected from an indium oxide, a tin oxide, and an indium-tin oxide, and said carbon atoms are contained in larger quantities in a portion of said transparent electrode (107) adjacent to said semiconductor layer (104, 105, 106) than in the bulk thereof.

2. A photovoltaic device according to claim 1, wherein said semiconductor layer is formed by stacking a p-type layer (104), an i-type layer (105) and an n-type layer (106).

3. A photovoltaic device according to claim 1, wherein said non-single-crystal semiconductor material is an amorphous semiconductor material.

4. A photovoltaic device according to claim 1, wherein said non-single-crystal semiconductor material is a polycrystal semiconductor material.

5. A photovoltaic device according to claim 1, wherein said carbon atoms are distributed so as to be decreased from a boundary between said transparent electrode (107) and said semiconductor layer (104, 105, 106) toward said transparent electrode (107) in a substantially exponential manner.

6. A photovoltaic device according to claim 1, wherein the maximum distribution density of said carbon atoms is 5 ppm to 1000 ppm.

7. A photovoltaic device according to claim 1, wherein said carbon atoms are, in an exponential manner, distributed in a region of 3 to 50 nm (30 to 500 Å) in a direction of the thickness of said electrode (107).

8. A photovoltaic device (100) comprising:
a conductive member (101);
a semiconductor layer (104, 105, 106) formed on said conductive member (101), made of a non-single-crystal silicon-based semiconductor material; and
a transparent electrode (107) stacked on said semiconductor layer (104, 105, 106),
wherein said transparent electrode (107) is made of an oxide containing nitrogen atoms, with the oxide being selected from an indium oxide, a tin oxide, and an indium-tin oxide, said nitrogen atoms are contained in larger quantities in a portion of said transparent electrode (107) adjacent to said semiconductor layer (104, 105, 106) than in the bulk thereof and the maximum distribution density of said nitrogen atoms is 5 ppm to 1000 ppm.

9. A photovoltaic device according to claim 8, wherein said semiconductor layer is formed by stacking a p-type layer (104), an i-type layer (105) and an n-type layer (106).

10. A photovoltaic device according to claim 8, wherein said non-single-crystal semiconductor material is an amorphous semiconductor material.

11. A photovoltaic device according to claim 8, wherein said non-single-crystal semiconductor material is a polycrystal semiconductor material.

12. A photovoltaic device according to claim 8, wherein said nitrogen atoms are distributed so as to be decreased from a boundary between said transparent electrode (107) and said semiconductor layer (104, 105, 106) toward said transparent electrode (107) in a substantially exponential manner.

13. A photovoltaic device according to claim 8, wherein said nitrogen atoms are, in an exponential manner, distributed in a region of 3 to 50 nm (30 to 500 Å) in a direction of the thickness of said electrode (107).

14. A photovoltaic device (100) comprising:
a conductive member (101);
a semiconductor layer (104, 105, 106) formed on said conductive member (101) made of a non-single-crystal silicon-based semiconductor material; and
a transparent electrode (107) stacked on said semiconductor layer (104, 105, 106),
wherein said transparent electrode (107) is made of an oxide containing carbon atoms and nitrogen atoms, with the oxide being selected from an indium oxide, a tin oxide, and an indium-tin oxide, and said carbon atoms and said nitrogen atoms are contained in larger quantities in a portion of said transparent electrode (107) adjacent to said semiconductor layer (104, 105, 106) than in the bulk thereof.

15. A photovoltaic device according to claim 14, wherein said semiconductor layer is formed by stacking a p-type layer (104), an i-type layer (105) and an n-type layer (106).

16. A photovoltaic device according to claim 14, wherein said non-single-crystal semiconductor material is an amorphous semiconductor material.

17. A photovoltaic device according to claim 14, wherein said non-single-crystal semiconductor material is a polycrystal semiconductor material.

18. A photovoltaic device according to claim 14, wherein said carbon atoms and said nitrogen atoms are distributed so as to be decreased from a boundary between said transparent electrode (107) and said semiconductor layer (104, 105, 106) toward said transparent electrode (107) in a substantially exponential manner.

19. A photovoltaic device according to claim 14, wherein the maximum distribution density of each of said carbon atoms and said nitrogen atoms is 5 ppm to 1000 ppm.

20. A photovoltaic device according to claim 14, wherein said carbon atoms and said nitrogen atoms are, in an exponential manner, distributed in a region of 3 to 50 nm (30 to 500 Å) in a direction of the thickness of said electrode (107).

## Patentansprüche

1. Photovoltaische Vorrichtung (100) mit
einem leitenden Element (101);
einer auf dem leitenden Element (101) ausgebildeten und aus einem Halbleitermaterial auf Nicht-Einkristallsilicium-Basis hergestellten Halbleiterschicht (104, 105, 106); und
einer auf der Halbleiterschicht (104, 105, 106) angeordneten transparenten Elektrode (107),
wobei die transparente Elektrode (107) aus einem Kohlenstoff enthaltenden Oxid hergestellt ist, das aus einem Indiumoxid, Zinnoxid und einem Indium-Zinn-Oxid ausgewählt ist, und wobei die Kohlenstoffatome in einem Abschnitt der transparenten Elektrode (107) benachbart zu der Halbleiterschicht (104, 105, 106) in größeren Mengen enthalten sind als in der Hauptmasse der transparenten Elektrode.

2. Photovoltaische Vorrichtung nach Anspruch 1, bei der die Halbleiterschicht durch Aufeinanderanordnen einer Schicht (104) vom p-Typ, einer Schicht (105) vom i-Typ und einer Schicht (106) vom n-Typ geformt ist.

3. Photovoltaische Vorrichtung nach Anspruch 1, bei der das Nicht-Einkristall-Halbleitermaterial ein amorphes Halbleitermaterial ist.

4. Photovoltaische Vorrichtung nach Anspruch 1, bei der das Nicht-Einkristall-Halbleitermaterial ein polykristallines Halbleitermaterial ist.

5. Photovoltaische Vorrichtung nach Anspruch 1, bei der die Kohlenstoffatome so verteilt sind, daß sie von der Grenze zwischen der transparenten Elektrode (107) und der Halbleiterschicht (104, 105, 106) in Richtung auf die transparente Elektrode (107) in einer im wesentlichen exponentiellen Weise abnehmen.

6. Photovoltaische Vorrichtung nach Anspruch 1, bei der die maximale Verteilungsdichte der Kohlenstoffatome 5 ppm bis 1000 ppm beträgt.

7. Photovoltaische Vorrichtung nach Anspruch 1, bei der die Kohlenstoffatome in exponentieller Weise in einem Bereich von 3 bis 50 nm (30 - 500 Å) in Dickenrichtung der Elektrode (107) verteilt sind.

8. Photovoltaische Vorrichtung (100) mit
einem leitenden Element (101);
einer auf dem leitenden Element (101) ausgebildeten und aus einem Halbleitermaterial auf Nicht-Einkristallsilicium-Basis hergestellten Halbleiterschicht (104, 105, 106) und
einer auf der Halbleiterschicht (104, 105, 106) angeordneten transparenten Elektrode (107),
wobei die transparente Elektrode (107) aus einem Stickstoffatome enthaltenden Oxid hergestellt ist, das aus einem Indiumoxid, einem Zinnoxid und einem Indium-Zinn-Oxid ausgewählt ist, und wobei die Stickstoffatome in größeren Mengen in einem Abschnitt der transparenten Elektrode (107) benachbart zur Halbleiterschicht (104, 105, 106) als in der Hauptmasse der transparenten Elektrode enthalten sind und die maximale Verteilungsdichte der Stickstoffatome 5 ppm bis 1000 ppm beträgt.

9. Photovoltaische Vorrichtung nach Anspruch 8, bei der die Halbleiterschicht durch Aufeinanderanordnen einer Schicht (104) vom p-Typ, einer Schicht (105) vom i-Typ und einer Schicht (106) vom n-Typ geformt ist.

10. Photovoltaische Vorrichtung nach Anspruch 8, bei der das Nicht-Einkristall-Halbleitermaterial ein amorphes Halbleitermaterial ist.

11. Photovoltaische Vorrichtung nach Anspruch 8, bei der das Nicht-Einkristall-Halbleitermaterial ein polykristallines Halbleitermaterial ist.

12. Photovoltaische Vorrichtung nach Anspruch 8, bei der die Stickstoffatome so verteilt sind, daß sie von der Grenze zwischen der transparenten Elektrode (107) und der Halbleiterschicht (104, 105, 106) in Richtung auf die transparente Elektrode (107) in einer im wesentlichen exponentiellen Weise abnehmen.

13. Photovoltaische Vorrichtung nach Anspruch 8, bei der die Stickstoffatome in exponentieller Weise in einem Bereich von 3 bis 50 nm (30 bis 500 Å) in Dickenrichtung der Elektrode (107) verteilt sind.

14. Photovoltaische Vorrichtung (100) mit
einem leitenden Element (101);
einer auf dem leitenden Element (101) ausgebildeten und aus einem Halbleitermaterial auf Nicht-Einkristallsilicium-Basis hergestellten Halbleiterschicht (104, 105, 106); und
einer auf der Halbleiterschicht (104, 105, 106) angeordneten transparenten Elektrode (107),
wobei die transparente Elektrode (107) aus einem Kohlenstoffatome und Stickstoffatome enthaltenden Oxid hergestellt ist, das aus einem Indiumoxid, einem Zinnoxid und einem Indium-Zinn-Oxid ausgewählt ist, und wobei die Kohlenstoffatome und Stickstoffatome in einem Abschnitt der transparenten Elektrode (107) benachbart zur Halbleiterschicht (104, 105, 106) in größeren Mengen enthalten sind als in der Hauptmasse der transparenten Elektrode.

15. Photovoltaische Vorrichtung nach Anspruch 14, bei der die Halbleiterschicht durch Aufeinanderanordnen einer Schicht (104) vom p-Typ, einer Schicht (105) vom i-Typ und einer Schicht (106) vom n-Typ geformt ist.

16. Photovoltaische Vorrichtung nach Anspruch 14, bei der das Nicht-Einkristall-Halbleitermaterial ein amorphes Halbleitermaterial ist.

17. Photovoltaische Vorrichtung nach Anspruch 14, bei der das Nicht-Einkristall-Halbleitermaterial ein polykristallines Halbleitermaterial ist.

18. Photovoltaische Vorrichtung nach Anspruch 14, bei der die Kohlenstoffatome und Stickstoffatome so verteilt sind, daß sie von der Grenze zwischen der transparenten Elektrode (107) und der Halbleiterschicht (104, 105, 106) in einer im wesentlichen exponentiellen Weise in Richtung auf die transparente Elektrode (107) abnehmen.

19. Photovoltaische Vorrichtung nach Anspruch 14, bei der die maximale Verteilungsdichte jeweils der Kohlenstoffatome und Stickstoffatome 5 ppm bis 1000 ppm beträgt.

20. Photovoltaische Vorrichtung nach Anspruch 14, bei der die Kohlenstoffatome und Stickstoffatome in exponentieller Weise in einem Bereich von 3 bis 50 nm (30 bis 500 Å) in Dickenrichtung der Elektrode (107) verteilt sind.

## Revendications

1. Dispositif photovoltaïque (100), comprenant :
un élément conducteur (101) ;
une couche semiconductrice (104, 105, 106) formée sur ledit élément conducteur (101), constituée d'une matière semiconductrice à base de silicium non monocristallin ; et
une électrode transparente (107) empilée sur ladite couche semiconductrice (104, 105, 106), dans lequel
ladite électrode transparente (107) est constituée d'un oxyde contenant des atomes de carbone, oxyde qui est choisi entre un oxyde d'indium, un oxyde d'étain et un oxyde d'indium-étain, et lesdits atomes de carbone sont présents en de plus grandes quantités dans une portion de ladite électrode transparente (107) adjacente à ladite couche semiconductrice (104, 105, 106) que dans la masse de cette électrode.

2. Dispositif photovoltaïque suivant la revendication 1, dans lequel la couche semiconductrice est formée en empilant une couche de type p (104) et une couche de type i (105) ainsi qu'une couche de type n (106).

3. Dispositif photovoltaïque suivant la revendication 1, dans lequel la matière semiconductrice non monocristalline est une matière semiconductrice amorphe.

4. Dispositif photovoltaïque suivant la revendication 1, dans lequel la matière semiconductrice non monocristalline est une matière semiconductrice polycristalline.

5. Dispositif photovoltaïque suivant la revendication 1, dans lequel les atomes de carbone sont distribués de manière à présenter une diminution depuis une limite entre l'électrode transparente (107) et la couche semiconductrice (104, 105, 106) vers ladite électrode transparente (107) d'une manière pratiquement exponentielle.

6. Dispositif photovoltaïque suivant la revendication 1, dans lequel la densité de distribution maximale des atomes de carbone va de 5 ppm à 1000 ppm.

7. Dispositif photovoltaïque suivant la revendication 1, dans lequel les atomes de carbone sont distribués, de manière exponentielle, dans une région de 3 à 50 nm (30 à 500 Å) dans une direction de l'épaisseur de l'électrode (107).

8. Dispositif photovoltaïque (100), comprenant :
un élément conducteur (101) ;
une couche semiconductrice (104, 105, 106) formée sur ledit élément conducteur (101), constituée d'une matière semiconductrice à base de silicium non monocristallin ; et
une électrode transparente (107) empilée sur ladite couche semiconductrice (104, 105, 106),
dans lequel ladite électrode transparente (107) est constituée d'un oxyde contenant des atomes d'azote, oxyde qui est choisi entre un oxyde d'indium, un oxyde d'étain et un oxyde d'indium-étain, lesdits atomes d'azote sont présents en de plus grande quantités dans une portion de ladite électrode transparente (107) adjacente à ladite couche semiconductrice (104, 105, 106) que dans la masse de cette électrode, et la densité de distribution maximale de ces atomes d'azote va de 5 ppm à 1000 ppm.

9. Dispositif photovoltaïque suivant la revendication 8, dans lequel la couche semiconductrice est formée en empilant une couche de type p (104), une couche de type i (105) et une couche de type n (106).

10. Dispositif photovoltaïque suivant la revendication 8, dans lequel la matière semiconductrice non monocristalline est une matière semiconductrice amorphe.

11. Dispositif photovoltaïque suivant la revendication 8, dans lequel la matière semiconductrice non monocristalline est une matière semiconductrice polycristalline.

12. Dispositif photovoltaïque suivant la revendication 8, dans lequel les atomes d'azote sont distribués de manière à présenter une diminution d'une limite entre l'électrode transparente (107) et la couche semiconductrice (104, 105, 106) vers ladite électrode transparente (107) d'une manière pratiquement exponentielle.

13. Dispositif photovoltaïque suivant la revendication 8, dans lequel les atomes d'azote sont distribués, de manière exponentielle, dans une région de 3 à 50 nm (30 à 500 Å) dans une direction de l'épaisseur de l'électrode (107).

14. Dispositif photovoltaïque (100), comprenant :
un élément conducteur (101) ;
une couche semiconductrice (104, 105, 106) formée sur ledit élément conducteur (101), constituée d'une matière semiconductrice à base de silicium non monocristallin ; et
une électrode transparente (107) empilée sur ladite couche semiconductrice (104, 105, 106),
dans lequel ladite électrode transparente (107) est constituée d'un oxyde contenant des atomes de carbone et des atomes d'azote, oxyde qui est choisi entre un oxyde d'indium, un oxyde d'étain et un oxyde d'indium-étain, et lesdits atomes de carbone et lesdits atomes d'azote sont présents en de plus grandes quantités dans une portion de ladite électrode transparente (107) adjacente à ladite couche semiconductrice (104, 105, 106) que dans la masse de cette électrode.

15. Dispositif photovoltaïque suivant la revendication 14, dans lequel la couche semiconductrice est formée en empilant une couche de type p (104), une couche de type i (105) et une couche de type n (106).

16. Dispositif photovoltaïque suivant la revendication 14, dans lequel la matière semiconductrice non monocristalline est une matière semiconductrice amorphe.

17. Dispositif photovoltaïque suivant la revendication 14, dans lequel la matière semiconductrice non monocristalline est une matière semiconductrice polycristalline.

18. Dispositif photovoltaïque suivant la revendication 14, dans lequel les atomes de carbone et les atomes d'azote sont distribués de manière à présenter une diminution depuis une limite entre l'électrode transparente (107) et la couche semiconductrice (104, 105, 106) vers ladite électrode transparente (107) d'une manière pratiquement exponentielle.

19. Dispositif photovoltaïque suivant la revendication 14, dans lequel la densité de distribution maximale de chacun des atomes de carbone et des atomes d'azote va de 5 ppm à 1000 ppm.

20. Dispositif photovoltaïque suivant la revendication 14, dans lequel les atomes de carbone et les atomes d'azote sont distribués, de manière exponentielle, dans une région de 3 à 50 nm (30 à 500 Å) dans une direction de l'épaisseur de l'électrode (107).
